# EUROPEAN PATENT APPLICATION

(11) **EP 4 306 225 A1**
(43) Date of publication of application: **17.01.2024**
(21) Application number: 22766694.8
(22) Date of filing: 04.02.2022
(51) Int. Cl.: B06B 1/06, H04R 17/00, H01L 41/047, H01L 41/083, H01L 41/09, H01L 41/113, H01L 41/18, H01L 41/187, H01L 41/23, H01L 41/29

(54) **MULTILAYER PIEZOELECTRIC ELEMENT**

(30) Priority: 12.03.2021 JP 2021040070; 07.05.2021 JP 2021079134; 06.07.2021 JP 2021112010
(71) Applicant: FUJIFILM Corporation, Tokyo 106-8620 (JP)
(72) Inventor: MIYOSHI, Tetsu, Minamiashigara-shi, Kanagawa 250-0193 (JP); KAGAWA, Yusuke, Minamiashigara-shi, Kanagawa 250-0193 (JP)
(74) Representative: Klunker IP Patentanwälte PartG mbB
(86) International application number: PCT/JP2022/004356
(87) International publication number: WO 2022/190729

(57) **Abstract**

Provided is a laminated piezoelectric element capable of suppressing heat generation while maintaining satisfactory piezoelectric characteristics. The laminated piezoelectric element is a laminated piezoelectric element including a piezoelectric film, in which the laminated piezoelectric element is obtained by laminating a plurality of layers of piezoelectric films each including a piezoelectric layer containing a polymer-based piezoelectric composite material that contains piezoelectric particles in a matrix containing a polymer material, and electrode layers formed on both surfaces of the piezoelectric layer, and in a case where a value obtained by dividing a capacitive reactance Xc of the piezoelectric film at a frequency of 1 kHz by an equivalent series resistance ESR is set to 1, a value XE₂₀ obtained by dividing the capacitive reactance Xc at a frequency of 20 kHz by the equivalent series resistance ESR is in a range of 0.6 to 1.5.

## Description

### BACKGROUND OF THE INVENTION

### 1. Field of the Invention

The present invention relates to a laminated piezoelectric element.

### 2. Description of the Related Art

With reduction in thickness of displays such as liquid crystal displays or organic EL displays, speakers used in these thin displays are also required to be lighter and thinner. Further, in flexible displays having flexibility, speakers are also required to have flexibility in order to be integrated with flexible displays without impairing lightness and flexibility. As such lightweight, thin, and flexible speakers, it is considered to employ sheet-like piezoelectric films having a property of stretching and contracting in response to an applied voltage.

It is also considered that a speaker having flexibility is obtained by bonding an exciter having flexibility to a vibration plate having flexibility. An exciter is an exciton that vibrates an article and produces a sound by being brought into contact with various articles and being attached thereto.

It has been suggested to use a piezoelectric composite material containing piezoelectric particles in a matrix as a sheet-like piezoelectric film having flexibility or an exciter.

For example, JP2014-014063A describes a piezoelectric film including a polymer-based piezoelectric composite material obtained by dispersing piezoelectric particles in a viscoelastic matrix formed of a polymer material having viscoelasticity at room temperature, thin film electrodes formed on both surfaces of the polymer-based piezoelectric composite material, and a protective layer formed on a surface of the thin film electrode.

### SUMMARY OF THE INVENTION

In such a piezoelectric film, deformation (vibration) of the piezoelectric layer is disturbed so that the output decreases in a case where the electrode layer is extremely thick. Therefore, the electrode layer is formed extremely thin. However, according to the examination conducted by the present inventors, it was found that a problem of an increase in the amount of heat generation occurs in a case where the thickness of the electrode layer is reduced.

An object of the present invention is to solve such a problem of the related art and to provide a laminated piezoelectric element capable of suppressing heat generation while maintaining satisfactory piezoelectric characteristics.

In order to achieve the above-described object, the present invention has the following configurations.
[1] A laminated piezoelectric element comprising: a piezoelectric film, in which the laminated piezoelectric element is obtained by laminating a plurality of layers of piezoelectric films each including a piezoelectric layer consisting of a polymer-based piezoelectric composite material that contains piezoelectric particles in a matrix containing a polymer material, and electrode layers formed on both surfaces of the piezoelectric layer, and in a case where a value obtained by dividing a capacitive reactance Xc of the piezoelectric film at a frequency of 1 kHz by an equivalent series resistance ESR is set to 1, a value XE₂₀ obtained by dividing the capacitive reactance Xc at a frequency of 20 kHz by the equivalent series resistance ESR is in a range of 0.6 to 1.5.
[2] The laminated piezoelectric element according to [1], in which the polymer material has viscoelasticity at room temperature.
[3] The laminated piezoelectric element according to [1] or [2], in which the value XE₂₀ is in a range of 0.8 to 1.3.
[4] The laminated piezoelectric element according to any one of [1] to [3], in which the electrode layers each have a thickness of 1 µm or less.
[5] The laminated piezoelectric element according to any one of [1] to [4], in which the piezoelectric film laminated at least on an outermost layer of the laminated piezoelectric element includes a protective layer laminated on a surface of the electrode layer on the outermost layer sides opposite to the piezoelectric layer, the protective layer has a hole portion penetrating from a surface to the electrode layer, and the laminated piezoelectric element has a conductive member disposed in the hole portion, and a conductive wire disposed on the surface of the hole portion of the protective layer and electrically connected to the electrode layer via the conductive member.
[6] The laminated piezoelectric element according to [5], in which in a case where an opening area of the hole portion is defined as A, a thickness of the electrode layer is defined as t, and a capacitance of the laminated piezoelectric element is defined as F, F/(A × t) is 260 µF/mm³ or less.

According to the present invention as described above, it is possible to provide a laminated piezoelectric element capable of suppressing heat generation while maintaining satisfactory piezoelectric characteristics.

### BRIEF DESCRIPTION OF THE DRAWINGS

Fig. 1 is a view conceptually illustrating an example of a laminated piezoelectric element of the present invention.
Fig. 2 is a view conceptually illustrating another example of a piezoelectric film.
Fig. 3 is a graph showing a relationship between a frequency, a capacitive reactance Xc, and an equivalent series resistance ESR.
Fig. 4 is a conceptual view for describing an example of a method of preparing a piezoelectric film.
Fig. 5 is a conceptual view for describing an example of a method of preparing a piezoelectric film.
Fig. 6 is a conceptual view for describing an example of a method of preparing a piezoelectric film.
Fig. 7 is a view conceptually illustrating another example of the laminated piezoelectric element of the present invention.
Fig. 8 is a graph showing a relationship between the frequency, the capacitive reactance Xc, and the equivalent series resistance ESR.
Fig. 9 is a graph showing a relationship between the frequency, the capacitive reactance Xc, and the equivalent series resistance ESR.
Fig. 10 is a graph showing a relationship between the frequency, the capacitive reactance Xc, and the equivalent series resistance ESR.
Fig. 11 is a graph showing a relationship between the frequency, the capacitive reactance Xc, and the equivalent series resistance ESR.
Fig. 12 is a graph showing a relationship between the frequency, the capacitive reactance Xc, and the equivalent series resistance ESR.
Fig. 13 is a graph showing a relationship between the frequency, the capacitive reactance Xc, and the equivalent series resistance ESR.
Fig. 14 is a graph showing a relationship between the frequency, the capacitive reactance Xc, and the equivalent series resistance ESR.
Fig. 15 is a plan view conceptually illustrating still another example of the laminated piezoelectric element of the present invention.
Fig. 16 is a side view of Fig. 15.
Fig. 17 is a partially enlarged view illustrating a cross section taken along line B-B of Fig. 16.
Fig. 18 is a partially enlarged view illustrating another example of the laminated piezoelectric element of the present invention.
Fig. 19 is a partially enlarged view illustrating another example of the piezoelectric film used in the laminated piezoelectric element of the present invention.
Fig. 20 is a cross-sectional view taken along line C-C of Fig. 19.

### DESCRIPTION OF THE PREFERRED EMBODIMENTS

Hereinafter, a laminated piezoelectric element according to the embodiment of the present invention will be described in detail based on suitable embodiments illustrated in the accompanying drawings.

The description of configuration requirements described below may be made based on typical embodiments of the present invention, but the present invention is not limited to such embodiments.

In addition, in the present specification, a numerical range shown using "to" indicates a range including numerical values described before and after "to" as a lower limit and an upper limit.

### [Laminated piezoelectric element]

The laminated piezoelectric element according to the embodiment of the present invention is a laminated piezoelectric element including a piezoelectric film, in which the laminated piezoelectric element is obtained by laminating a plurality of layers of piezoelectric films each including a piezoelectric layer containing a polymer-based piezoelectric composite material that contains piezoelectric particles in a matrix containing a polymer material, and electrode layers formed on both surfaces of the piezoelectric layer, and in a case where a value obtained by dividing a capacitive reactance Xc of the piezoelectric film at a frequency of 1 kHz by an equivalent series resistance ESR is set to 1, a value XE₂₀ obtained by dividing the capacitive reactance Xc at a frequency of 20 kHz by the equivalent series resistance ESR is in a range of 0.6 to 1.5.

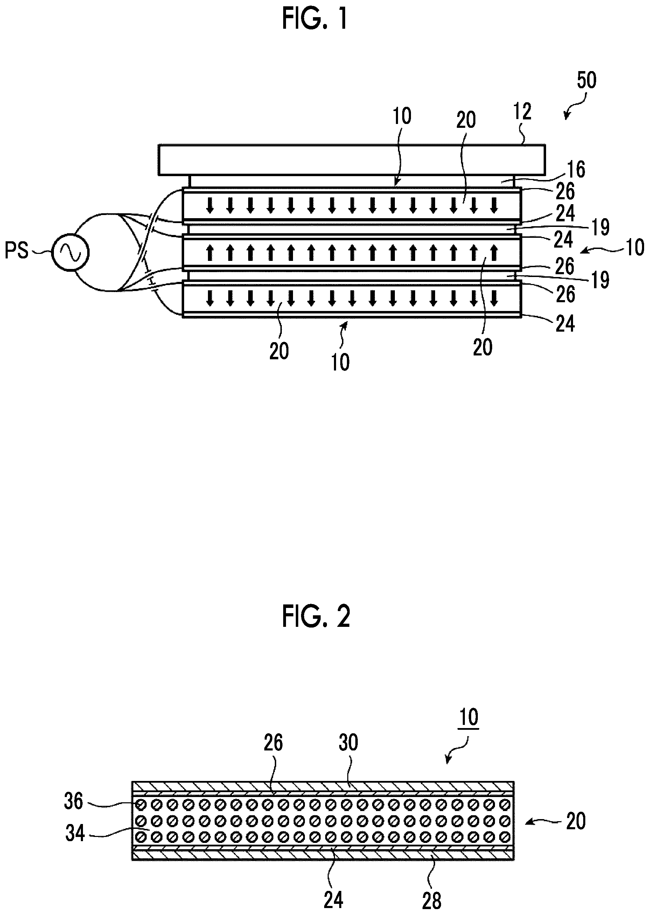

Fig. 1 conceptually illustrates an example of the laminated piezoelectric element according to the embodiment of the present invention.

A laminated piezoelectric element 50 illustrated in Fig. 1 has a configuration in which three sheets of piezoelectric films 10 including a first electrode layer 24 on one surface of a piezoelectric layer 20 and a second electrode layer 26 on the other surface of the piezoelectric layer 20 are laminated and the adjacent piezoelectric films are bonded to each other with an adhesive layer (bonding layer) 19. The configuration of the piezoelectric film 10 will be described in detail below. Each piezoelectric film 10 is connected to a power source in parallel. That is, the first electrode layer 24 of each piezoelectric film 10 is electrically connected to one electrode of a power source by a wire, and the second electrode layer 26 of each piezoelectric film 10 is electrically connected to the other electrode of the power source by a wire.

Further, the first protective layer 28 and the second protective layer 30 of each piezoelectric film 10 are not illustrated in Fig. 1, but each piezoelectric film 10 may include a first protective layer 28 and a second protective layer 30.

Further, the laminated piezoelectric element 50 illustrated in Fig. 1 is formed by laminating three piezoelectric films 10, but the present invention is not limited thereto. That is, the number of laminated piezoelectric films may be two layers or four or more layers as long as the laminated piezoelectric element of the present invention is formed by laminating a plurality of layers of the piezoelectric films. From this viewpoint, the same applies to the laminated piezoelectric element described below.

As a preferred embodiment, the laminated piezoelectric element 50 illustrated in Fig. 1 is laminated such that the polarization directions in the adjacent piezoelectric films 10 are opposite to each other as indicated by the arrows shown in the piezoelectric layer 20. Further, the laminated piezoelectric element 50 according to the embodiment of the present invention is not limited thereto, and the polarization directions of adjacent piezoelectric films 10 may be the same as each other.

As illustrated in Fig. 1, the laminated piezoelectric element 50 is used as an exciter that adheres to a vibration plate 12 via an adhesive layer 16 and generates a sound from the vibration plate 12. In other words, the vibration plate 12 and the piezoelectric film 10 are in contact with each other and fixed to each other via the adhesive layer 16, and the piezoelectric film 10 acts as an exciter for generating a sound from the vibration plate 12.

The laminated piezoelectric element 50 is obtained by laminating a plurality of the piezoelectric films 10. Therefore, even in a case where the rigidity of each piezoelectric film 10 is low and the stretching and contracting force thereof is small, the rigidity is increased by laminating the piezoelectric films 10, and the stretching and contracting force as the laminated piezoelectric element 50 is increased. As a result, in the laminated piezoelectric element 50, even in a case where the vibration plate 12 has a certain degree of rigidity, the vibration plate 12 is sufficiently bent with a large force and can be sufficiently vibrated in the thickness direction, and thus a sound can be generated from the vibration plate 12.

Further, in a case where the thickness of the piezoelectric layer 20 increases, the stretching and contracting force of the piezoelectric film increases, but the driving voltage required for stretching and contracting the film is increased by the same amount. Here, as described below, in the piezoelectric film 10, since the maximum thickness of the piezoelectric layer 20 is preferably approximately 300 µm, the piezoelectric film 10 can be sufficiently stretched and contracted even in a case where the voltage applied to each piezoelectric film 10 is small.

A power source that applies a driving voltage for stretching and contracting the piezoelectric film 10 is connected to the first electrode layer 24 and the second electrode layer 26 of each piezoelectric film 10.

The power source is not limited and may be a direct-current power source or an alternating-current power source. In addition, as for the driving voltage, a driving voltage capable of appropriately driving each of the piezoelectric films may be appropriately set according to the thickness, the forming material, and the like of the piezoelectric layer 20 of each piezoelectric film.

Further, as illustrated in Fig. 1, it is preferable that the piezoelectric film is connected to the power source such that the relationship between the polarization direction of each piezoelectric film and the polarity of the electrode layer is the same for all the piezoelectric films. In this manner, a voltage having the same phase can be applied to each piezoelectric film. That is, in a case where a voltage is applied to the piezoelectric films, the behaviors of stretching and contracting all the piezoelectric films are in the same phase. Therefore, the stretch and the contract of each piezoelectric film can be strengthened, and the deformation (output) of the entire piezoelectric film can be increased. That is, high piezoelectric characteristics can be obtained.

Further, in the present invention, the polarization direction of the piezoelectric film may be detected by a d33 meter or the like.

Alternatively, the polarization direction of the piezoelectric layer 20 may be known from the treatment conditions of the corona poling treatment described above.

### [Piezoelectric film]

Fig. 2 is a cross-sectional view conceptually illustrating an example of the piezoelectric film.

As illustrated in Fig. 2, the piezoelectric film 10 includes a piezoelectric layer 20 which is a sheet-like material having piezoelectric properties, a first electrode layer 24 laminated on one surface of the piezoelectric layer 20, a first protective layer 28 laminated on the first electrode layer 24, a second electrode layer 26 laminated on the other surface of the piezoelectric layer 20, and a second protective layer 30 laminated on the second electrode layer 26.

The piezoelectric layer 20 consists of a polymer-based piezoelectric composite material containing the piezoelectric particles 36 in a matrix 34 containing a polymer material. In addition, the first electrode layer 24 and the second electrode layer 26 are electrode layers of the present invention.

As will be described later, the piezoelectric film 10 (piezoelectric layer 20) is polarized in the thickness direction as a preferred embodiment.

As an example, the piezoelectric film 10 is used in various acoustic devices (audio equipment) such as speakers, microphones, and pickups used in musical instruments such as guitars, to generate (reproduce) a sound due to vibration in response to an electrical signal or convert vibration due to a sound into an electrical signal.

Further, the piezoelectric film can also be used in pressure sensitive sensors, power generation elements, and the like in addition to the examples described above.

Alternatively, the piezoelectric film can also be used as an exciter that vibrates an article and generates a sound by being brought into contact with and attached to various articles.

In the piezoelectric film 10, the second electrode layer 26 and the first electrode layer 24 form a pair of electrodes. That is, the piezoelectric film 10 has a configuration in which both surfaces of the piezoelectric layer 20 are sandwiched between the electrode pair, that is, the first electrode layer 24 and the second electrode layer 26, and the laminate is further sandwiched between the first protective layer 28 and the second protective layer 30.

As described above, in the piezoelectric film 10, the region sandwiched between the first electrode layer 24 and the second electrode layer 26 stretches and contracts according to the applied voltage.

Further, the first electrode layer 24 and the first protective layer 28, and the second electrode layer 26 and the second protective layer 30 are named according to the polarization direction of the piezoelectric layer 20. Therefore, the first electrode layer 24 and the second electrode layer 26, and the first protective layer 28 and the second protective layer 30 have configurations that are basically the same as each other.

Further, in addition to the above-described layers, the piezoelectric film 10 may include an insulating layer that covers a region where the piezoelectric layer 20 on a side surface or the like is exposed for preventing a short circuit or the like.

In a case where a voltage is applied to the first electrode layer 24 and the second electrode layer 26 of the piezoelectric film 10, the piezoelectric particles 36 stretch and contract in the polarization direction according to the applied voltage. As a result, the piezoelectric film 10 (piezoelectric layer 20) contracts in the thickness direction. At the same time, the piezoelectric film 10 stretches and contracts in the in-plane direction due to the Poisson's ratio. The degree of stretch and contraction is approximately in a range of 0.01% to 0.1%. In the in-plane direction, the stretch and contraction are isotropically made in all directions.

The thickness of the piezoelectric layer 20 is preferably approximately in a range of 10 to 300 µm. Therefore, the degree of stretch and contraction in the thickness direction is as extremely small as approximately 0.3 µm at the maximum.

On the contrary, the piezoelectric film 10, that is, the piezoelectric layer 20, has a size much larger than the thickness in the plane direction. Therefore, for example, in a case where the length of the piezoelectric film 10 is 20 cm, the piezoelectric film 10 stretches and contracts by a maximum of approximately 0.2 mm by the application of a voltage.

Further, in a case where a pressure is applied to the piezoelectric film 10, electric power is generated by the action of the piezoelectric particles 36.

By utilizing this, the piezoelectric film 10 can be used for various applications such as a speaker, a microphone, and a pressure sensitive sensor as described above.

Here, in the present invention, in a case where the value obtained by dividing the capacitive reactance Xc of the piezoelectric film 10 at a frequency of 1 kHz by the equivalent series resistance ESR is set to 1, the value XE₂₀ obtained by dividing the capacitive reactance Xc at a frequency of 20 kHz by the equivalent series resistance ESR is in a range of 0.6 to 1.5.

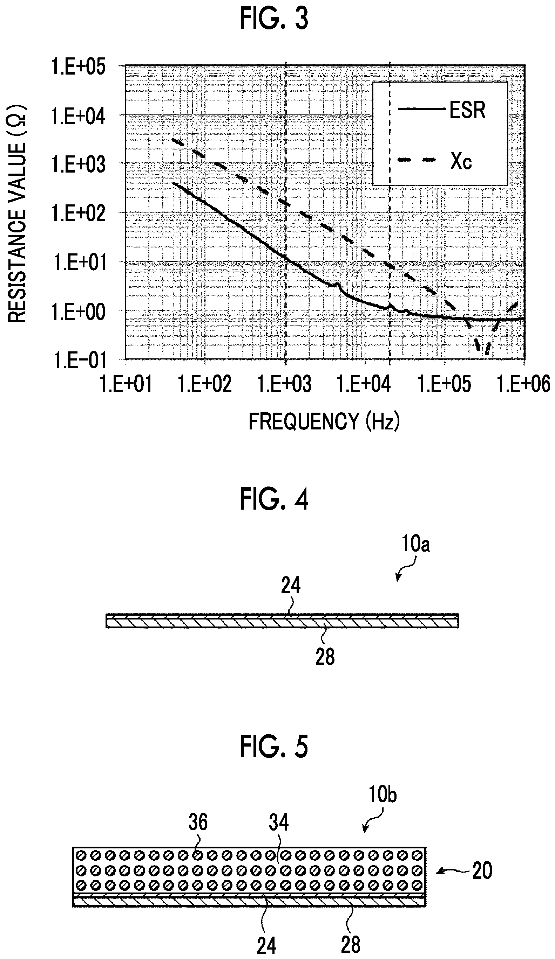

The details will be described with reference to Fig. 3.

Fig. 3 is a graph conceptually illustrating the frequency characteristics of the capacitive reactance Xc and the equivalent series resistance ESR of the piezoelectric film 10.

A configuration in which a piezoelectric layer serving as a dielectric is sandwiched between an electrode pair is represented by an equivalent circuit in which a capacitance, an equivalent series inductance, and an equivalent series resistance are connected in series, similarly to a condenser or the like. Here, in an audible range (20 Hz to 20 kHz) where the piezoelectric film of the present invention is used, the equivalent series inductance does not contribute, and thus the piezoelectric film 10 can be expressed as an equivalent circuit in which a capacitance C and the equivalent series resistance ESR are connected in series.

In such an equivalent circuit, since the capacitive reactance Xc = 1/(2π × f × C) due to the capacitance C is inversely proportional to a frequency f of the power source, the capacitive reactance Xc decreases as the frequency increases as illustrated in Fig. 3. The capacitive reactance Xc is a ratio between the voltage and the current in a case where the piezoelectric layer is driven.

Meanwhile, the equivalent series resistance ESR corresponds to heat generation due to a resistance component. The equivalent series resistance ESR is caused by a resistance component of the piezoelectric layer, a resistance component of the electrode layer, and the like. It is considered that the heat generated from the piezoelectric layer appears as frictional heat in a case where the piezoelectric particles contained in the piezoelectric layer cause a domain motion. In a case where the frequency of the power source is increased in such a piezoelectric layer, since the movement of the domain motion does not follow the frequency, the frictional heat due to the domain motion is considered to be reduced.

Further, the resistance component of the electrode layer is substantially constant regardless of the frequency. Therefore, as illustrated in Fig. 3, the equivalent series resistance ESR decreases as the frequency increases, and is thus substantially constant after a certain frequency.

From the viewpoint of suppressing the heat generation of the piezoelectric layer, the equivalent series resistance ESR may be reduced.

Here, in the piezoelectric layer, the piezoelectric performance is typically higher as the domain motion is more active. That is, the piezoelectric layer with high piezoelectric performance tends to generate a large amount of heat. Therefore, it is difficult to suppress heat generation from the piezoelectric layer without sacrificing the piezoelectric performance. Therefore, it is difficult to reduce the equivalent series resistance ESR in a low frequency region where the contribution of the piezoelectric layer is large.

In addition, the contribution of the piezoelectric layer is relatively small and the contribution of the resistance component of the electrode layer or the like is large in a region where the frequency is high (10 kHz to 20 kHz).

Meanwhile, the equivalent series resistance ESR varies depending on the size of the piezoelectric film and the like. Further, the capacitive reactance Xc also depends on the size of the piezoelectric film and the like. Therefore, the resistance component excluding the influence of the size can be evaluated by evaluating the value of the ratio between the equivalent series resistance ESR and the capacitive reactance Xc.

In the present invention, in a case where a value XE₁ obtained by dividing the capacitive reactance Xc of the piezoelectric film at a frequency of 1 kHz by the equivalent series resistance ESR is set to 1, the value XE₂₀ obtained by dividing the capacitive reactance Xc at a frequency of 20 kHz by the ESR is in a range of 0.6 to 1.5. That is, in a case where the value XE₂₀ at a frequency of 20 kHz is set to be close to the value XE₁ at a frequency of 1 kHz, the ratio of the heat-generated energy to the energy used for the piezoelectric effect in the input energy at a frequency of 20 kHz is set to be close to a value at a frequency of 1 kHz. In this manner, the heat generation can be suppressed while satisfactory piezoelectric characteristics are maintained.

Since the highest current flows at 20 kHz in the audio band, in a case where the value XE₂₀ is less than 0.6, the heat generation increases, and a problem of thermal runaway may occur in the worst case.

Further, in a case where the value XE₂₀ is greater than 1.5, for example, the ESR at 30 kHz decreases as the thickness of the electrode layer greatly increases, but the ESR at 20 kHz does not almost change, and thus it is considered that there is substantially no advantage in an audio band of 20 kHz.

From the above-described viewpoint, the value XE₂₀ is preferably in a range of 0.6 to 1.5, more preferably in a range of 0.8 to 1.3, and still more preferably in a range of 1.0 to 1.1.

Changes in the capacitive reactance Xc and the equivalent series resistance ESR with respect to frequency can be measured, for example, by an impedance analyzer 4294A (manufactured by Agilent).

It is preferable to reduce the resistance of the electrode layer in order to set the value XE₂₀ to be in the above-described ranges. Examples of a method of suppressing the resistance of the electrode layer include a method of increasing the thickness of the electrode layer, a method of shortening the length of a path through which the current flows, a method of using a material with a low volume resistivity as the material of the electrode layer, and a method of controlling the film quality of the electrode layer. Further, in a case where a plurality of piezoelectric films are laminated and used as in the laminated piezoelectric element according to the embodiment of the present invention, the resistance of the entire piezoelectric element can also be reduced by connecting the plurality of piezoelectric films in parallel. Further, the value XE₂₀ may be set to be in the above-described ranges by combining a plurality of the above-described methods.

Here, as described above, in a case where the electrode layer is extremely thick, the deformation (vibration) of the piezoelectric layer is disturbed and the output (piezoelectric characteristic) is decreased. Therefore, it is preferable that the electrode layer is thick enough not to degrade the piezoelectric characteristics, but it is difficult to set the value XE₂₀ to be in the above-described ranges only by adjusting the thickness. Further, the length of the path through which the current flows can be adjusted by examining the position where the electrode and the wire from the power source are brought into contact with each other, but it is difficult to sufficiently shorten the length depending on the size of the piezoelectric film and difficult to set the value XE₂₀ to be in the above-described ranges only by adjusting the length of the path.

Therefore, it is preferable to combine a plurality of the above-described methods so that the value XE₂₀ is set to be in the above-described ranges.

### <Piezoelectric layer>

The piezoelectric layer is a layer consisting of a polymer-based piezoelectric composite material that contains piezoelectric particles in a matrix containing a polymer material and is a layer that exhibits a piezoelectric effect in which the layer is stretched and contracted in a case where a voltage is applied.

In the piezoelectric film 10, as a preferred embodiment, the piezoelectric layer 20 consists of a polymer-based piezoelectric composite material in which piezoelectric particles 36 are dispersed in the matrix 34 consisting of a polymer material having viscoelasticity at room temperature. Further, in the present specification, the "room temperature" indicates a temperature range of approximately 0°C to 50°C.

Here, it is preferable that the polymer-based piezoelectric composite material (piezoelectric layer 20) satisfies the following requirements.

### (i) Flexibility

For example, in a case of being gripped in a state of being loosely bent like a document such as a newspaper or a magazine as a portable device, the piezoelectric film is continuously subjected to large bending deformation from the outside at a relatively slow vibration of less than or equal to a few Hz. In this case, in a case where the polymer-based piezoelectric composite material is hard, a large bending stress is generated to that extent, and a crack is generated at the interface between a polymer matrix and piezoelectric particles, which may lead to breakage. Accordingly, the polymer-based piezoelectric composite material is required to have suitable flexibility. In addition, in a case where strain energy is diffused into the outside as heat, the stress is able to be relaxed. Therefore, the polymer-based piezoelectric composite material is required to have a suitably large loss tangent.

As described above, a flexible polymer-based piezoelectric composite material used as an exciter is required to be rigid with respect to a vibration of 20 Hz to 20 kHz and to be flexible with respect to a vibration of less than or equal to a few Hz. In addition, the loss tangent of a polymer-based piezoelectric composite material is required to be suitably large with respect to the vibration of all frequencies of 20 kHz or less.

Further, it is preferable that the spring constant can be easily adjusted by performing lamination according to the rigidity (the hardness, the stiffness, or the spring constant) of a mating material (vibration plate) to be attached, and the energy efficiency can increase as the thickness of the adhesive layer decreases.

In general, a polymer solid has a viscoelasticity relaxing mechanism, and a molecular movement having a large scale is observed as a decrease (relief) in a storage elastic modulus (Young's modulus) or a maximal value (absorption) in a loss elastic modulus along with an increase in temperature or a decrease in frequency. Among these, the relaxation due to a microbrown movement of a molecular chain in an amorphous region is referred to as main dispersion, and an extremely large relaxing phenomenon is observed. A temperature at which this main dispersion occurs is a glass transition point (Tg), and the viscoelasticity relaxing mechanism is most remarkably observed.

In the polymer-based piezoelectric composite material (piezoelectric layer 20), the polymer-based piezoelectric composite material exhibiting a behavior of being rigid with respect to a vibration of 20 Hz to 20 kHz and being flexible with respect to a vibration of less than or equal to a few Hz is realized by using a polymer material whose glass transition point is room temperature, that is, a polymer material having a viscoelasticity at room temperature as a matrix. In particular, from the viewpoint that such a behavior is suitably exhibited, it is preferable that a polymer material in which the glass transition point at a frequency of 1 Hz is at room temperature, that is, in a range of 0°C to 50°C is used for a matrix of the polymer-based piezoelectric composite material.

As the polymer material having a viscoelasticity at room temperature, various known materials can be used. It is preferable that a polymer material in which the maximal value of a loss tangent Tanδ at a frequency of 1 Hz according to a dynamic viscoelasticity test at room temperature, that is, in a range of 0°C to 50° is 0.5 or greater is used as the polymer material.

In this manner, in a case where the polymer-based piezoelectric composite material is slowly bent due to an external force, stress concentration on the interface between the polymer matrix and the piezoelectric particles at the maximum bending moment portion is relaxed, and thus high flexibility can be expected.

In the polymer material having a viscoelasticity at room temperature, it is preferable that a storage elastic modulus (E') at a frequency of 1 Hz according to the dynamic viscoelasticity measurement is 100 MPa or greater at 0°C and 10 MPa or less at 50°C.

In this manner, the bending moment generated in a case where the polymer-based piezoelectric composite material is slowly bent due to the external force can be reduced, and the polymer-based piezoelectric composite material can exhibit a behavior of being rigid with respect to an acoustic vibration of 20 Hz to 20 kHz.

In addition, it is more suitable that the relative dielectric constant of the polymer material having a viscoelasticity at room temperature is 10 or greater at 25°C. Accordingly, in a case where a voltage is applied to the polymer-based piezoelectric composite material, a higher electric field is applied to the piezoelectric particles in the polymer matrix, and thus a large deformation amount can be expected.

However, in consideration of ensuring satisfactory moisture resistance and the like, it is suitable that the relative dielectric constant of the polymer material is 10 or less at 25°C.

Examples of the polymer material having a viscoelasticity at room temperature and satisfying such conditions include cyanoethylated polyvinyl alcohol (cyanoethylated PVA), polyvinyl acetate, polyvinylidene chloride-co-acrylonitrile, a polystyrene-vinyl polyisoprene block copolymer, polyvinyl methyl ketone, and polybutyl methacrylate. In addition, as these polymer materials, a commercially available product such as Hybrar 5127 (manufactured by Kuraray Co., Ltd.) can also be suitably used. Among these, it is preferable to use a material containing a cyanoethyl group and particularly preferable to use cyanoethylated PVA as the polymer material.

Further, these polymer materials may be used alone or in combination (mixture) of a plurality of kinds thereof.

In the matrix 34 for which such a polymer material having a viscoelasticity at room temperature is used, a plurality of polymer materials may be used in combination as necessary.

That is, other dielectric polymer materials may be added to the matrix 34 for the purpose of adjusting dielectric properties or mechanical properties, in addition to the viscoelastic material such as cyanoethylated PVA as necessary.

Examples of the dielectric polymer material that can be added thereto include a fluorine-based polymer such as polyvinylidene fluoride, a vinylidene fluoride-tetrafluoroethylene copolymer, a vinylidene fluoride-trifluoroethylene copolymer, a polyvinylidene fluoride-trifluoroethylene copolymer, or a polyvinylidene fluoride-tetrafluoroethylene copolymer, a polymer containing a cyano group or a cyanoethyl group such as a vinylidene cyanide-vinyl acetate copolymer, cyanoethyl cellulose, cyanoethyl hydroxysaccharose, cyanoethyl hydroxycellulose, cyanoethyl hydroxypullulan, cyanoethyl methacrylate, cyanoethyl acrylate, cyanoethyl hydroxyethyl cellulose, cyanoethyl amylose, cyanoethyl hydroxypropyl cellulose, cyanoethyl dihydroxypropyl cellulose, cyanoethyl hydroxypropyl amylose, cyanoethyl polyacrylamide, cyanoethyl polyacrylate, cyanoethyl pullulan, cyanoethyl polyhydroxymethylene, cyanoethyl glycidol pullulan, cyanoethyl saccharose, or cyanoethyl sorbitol, and synthetic rubber such as nitrile rubber or chloroprene rubber.

Among these, a polymer material containing a cyanoethyl group is suitably used.

Further, the number of kinds of the dielectric polymers to be added to the matrix 34 of the piezoelectric layer 20 in addition to the material having a viscoelasticity at room temperature, such as cyanoethylated PVA, is not limited to one, and a plurality of kinds of the materials may be added.

In addition, for the purpose of adjusting the glass transition point Tg, a thermoplastic resin such as a vinyl chloride resin, polyethylene, polystyrene, a methacrylic resin, polybutene, or isobutylene, and a thermosetting resin such as a phenol resin, a urea resin, a melamine resin, an alkyd resin, or mica may be added to the matrix 34 in addition to the dielectric polymers.

Further, for the purpose of improving the pressure sensitive adhesiveness, a viscosity imparting agent such as rosin ester, rosin, terpene, terpene phenol, or a petroleum resin may be added.

In the matrix 34 of the piezoelectric layer 20, the addition amount in a case of adding materials other than the polymer material having viscoelasticity such as cyanoethylated PVA is not particularly limited, but is preferably set to 30% by mass or less in terms of the proportion of the materials in the matrix 34.

In this manner, the characteristics of the polymer material to be added can be exhibited without impairing the viscoelasticity relaxing mechanism in the matrix 34, and thus preferable results, for example, an increase in the dielectric constant, improvement of the heat resistance, and improvement of the adhesiveness between the piezoelectric particles 36 and the electrode layer can be obtained.

The piezoelectric particles 36 consist of ceramics particles having a perovskite type or wurtzite type crystal structure.

As the ceramics particles forming the piezoelectric particles 36, for example, lead zirconate titanate (PZT), lead lanthanum zirconate titanate (PLZT), barium titanate (BaTiO₃), zinc oxide (ZnO), and a solid solution (BFBT) of barium titanate and bismuth ferrite (BiFe₃) are exemplified.

The particle diameter of such piezoelectric particles 36 is not limited, and may be appropriately selected depending on the size of the piezoelectric film 10, the applications of the piezoelectric film 10, and the like. The particle diameter of the piezoelectric particles 36 is preferably in a range of 1 to 10 µm.

By setting the particle diameter of the piezoelectric particles 36 to be in this range, a preferable result is able to be obtained from a viewpoint of allowing the piezoelectric film 10 to achieve both high piezoelectric characteristics and flexibility.

In Fig. 2, the piezoelectric particles 36 in the piezoelectric layer 20 are uniformly dispersed in the matrix 34 with regularity, but the present invention is not limited thereto.

That is, the piezoelectric particles 36 in the piezoelectric layer 20 may be irregularly dispersed in the matrix 34 as long as the piezoelectric particles 36 are preferably uniformly dispersed therein.

In the piezoelectric film 10, the ratio between the amount of the matrix 34 and the amount of the piezoelectric particles 36 in the piezoelectric layer 20 is not limited and may be appropriately set according to the size and the thickness of the piezoelectric film 10 in the plane direction, the applications of the piezoelectric film 10, the characteristics required for the piezoelectric film 10, and the like.

The volume fraction of the piezoelectric particles 36 in the piezoelectric layer 20 is preferably in a range of 30% to 80%, more preferably 50% or greater, and still more preferably in a range of 50% to 80%.

By setting the ratio between the amount of the matrix 34 and the amount of the piezoelectric particles 36 to be in the above-described ranges, preferable results in terms of achieving both of excellent piezoelectric characteristics and flexibility can be obtained.

In the piezoelectric film 10 described above, as a preferred embodiment, the piezoelectric layer 20 is a polymer-based piezoelectric composite material in which piezoelectric particles are dispersed in the viscoelastic matrix containing a polymer material having viscoelasticity at room temperature. However, the present invention is not limited thereto, and a polymer-based piezoelectric composite material in which piezoelectric particles are dispersed in a matrix containing a polymer material, which is used in a known piezoelectric element, can be used as a piezoelectric layer.

In the piezoelectric film 10, the thickness of the piezoelectric layer 20 is not particularly limited and may be appropriately set according to the applications of the piezoelectric film 10, the number of times of lamination of the piezoelectric film 10 in the piezoelectric element described below, and the characteristics required for the piezoelectric film 10, and the like.

The thicker the piezoelectric layer 20, the more advantageous it is in terms of rigidity such as the stiffness of a so-called sheet-like material, but the voltage (potential difference) required to stretch and contract the piezoelectric film 10 by the same amount increases.

The thickness of the piezoelectric layer 20 is preferably in a range of 10 to 300 µm, more preferably in a range of 20 to 200 µm, and still more preferably in a range of 30 to 150 µm.

By setting the thickness of the piezoelectric layer 20 to be in the above-described range, preferable results in terms of achieving both ensuring of the rigidity and moderate elasticity can be obtained.

### <Protective layer>

The first protective layer 28 and the second protective layer 30 in the piezoelectric film 10 have a function of coating the second electrode layer 26 and the first electrode layer 24 and imparting moderate rigidity and mechanical strength to the piezoelectric layer 20. That is, the piezoelectric layer 20 consisting of the matrix 34 and the piezoelectric particles 36 in the piezoelectric film 10 exhibits extremely excellent flexibility under bending deformation at a slow vibration, but may have insufficient rigidity or mechanical strength depending on the applications. As a compensation for this, the piezoelectric film 10 is provided with the first protective layer 28 and the second protective layer 30.

The first protective layer 28 and the second protective layer 30 are not limited, and various sheet-like materials can be used, and suitable examples thereof include various resin films.

Among these, from the viewpoints of excellent mechanical characteristics and heat resistance, a resin film consisting of polyethylene terephthalate (PET), polypropylene (PP), polystyrene (PS), polycarbonate (PC), polyphenylene sulfite (PPS), polymethylmethacrylate (PMMA), polyetherimide (PEI), polyimide (PI), polyethylene naphthalate (PEN), triacetyl cellulose (TAC), and a cyclic olefin-based resin is suitably used.

The thickness of the first protective layer 28 and the second protective layer 30 is not limited. In addition, the thicknesses of the first protective layer 28 and the second protective layer 30 are basically the same as each other, but may be different from each other.

Here, in a case where the rigidity of the first protective layer 28 and the second protective layer 30 is extremely high, not only is the stretch and contraction of the piezoelectric layer 20 constrained, but also the flexibility is impaired. Therefore, it is advantageous that the thickness of the first protective layer 28 and the thickness of the second protective layer 30 decrease except for the case where the mechanical strength or satisfactory handleability as a sheet-like material is required.

In a case where the thickness of the first protective layer 28 and the second protective layer 30 in the piezoelectric film 10 is two times or less the thickness of the piezoelectric layer 20, preferable results in terms of achieving both ensuring of the rigidity and moderate elasticity can be obtained.

For example, in a case where the thickness of the piezoelectric layer 20 is 50 µm and the first protective layer 28 and the second protective layer 30 consist of PET, the thickness of the first protective layer 28 and the second protective layer 30 is preferably 100 µm or less, more preferably 50 µm or less, and still more preferably 25 µm or less.

### <Electrode layer>

In the piezoelectric film 10, the first electrode layer 24 is formed between the piezoelectric layer 20 and the first protective layer 28, and the second electrode layer 26 is formed between the piezoelectric layer 20 and the second protective layer 30. The first electrode layer 24 and the second electrode layer 26 are provided to apply a voltage to the piezoelectric layer 20 (piezoelectric film 10).

In the present invention, the material for forming the first electrode layer 24 and the second electrode layer 26 is not limited, and various conductors can be used as the material. Specific examples thereof include metals such as carbon, palladium, iron, tin, aluminum, nickel, platinum, gold, silver, copper, titanium, chromium, and molybdenum, alloys thereof, laminates and composites of these metals and alloys, and indium tin oxide. Among these, copper, aluminum, gold, silver, platinum, and indium tin oxide are suitable examples of the materials of the first electrode layer 24 and the second electrode layer 26 from the viewpoint of easily setting the value XE₂₀ to be in the above-described ranges.

In addition, a method of forming the first electrode layer 24 and the second electrode layer 26 is not limited, and various known methods, for example, a vapor-phase deposition method (a vacuum film forming method) such as vacuum vapor deposition, ion-assisted vapor deposition, or sputtering, a film forming method of using plating, and a method of bonding a foil formed of the materials described above can be used.

Here, even in a case where the same material is used as the material of the electrode layer, the resistance changes depending on the film quality of the electrode layer (metal film). For example, the resistance increases as the number of crystal grain boundaries, voids, and the like in the film increases. Therefore, it is preferable to control the method of forming the electrode layer and the conditions for forming the electrode layer to adjust the film quality of the electrode layer.

From the viewpoint that a film with a satisfactory film quality and a low resistance can be formed, ion-assisted vapor deposition and sputtering are preferable as the forming method. Metal thin films grown by vapor phase deposition methods such as sputtering and vapor deposition typically have a columnar structure, and since the electric resistance thereof is determined by the crystal grain boundary density per unit area, an ideal columnar structure consists of crystal grains that are as thick as possible. For example, in a case of sputtering, a dense columnar structure with less voids and a large crystal grain size can be obtained by increasing the base material temperature as much as possible to promote surface diffusion, reducing the gas pressure to lengthen the mean free path, and suppressing the projection effect. Further, it is also effective to promote surface diffusion by driving fast charged particles such as ion assist into the base material.

The thicknesses of the first electrode layer 24 and the second electrode layer 26 are not limited. In addition, the thicknesses of the first electrode layer 24 and the second electrode layer 26 are basically the same as each other, but may be different from each other.

Here, similarly to the first protective layer 28 and the second protective layer 30 described above, in a case where the rigidity of the first electrode layer 24 and the second electrode layer 26 is extremely high, not only is the stretch and contraction of the piezoelectric layer 20 constrained, but also the flexibility is impaired. Therefore, from the viewpoints of the flexibility and the piezoelectric characteristics, the first electrode layer 24 and the second electrode layer 26 are more advantageous as the thicknesses thereof decrease. Further, in a case where the first electrode layer 24 and the second electrode layer 26 are extremely thin, the electric resistance increases, and thus the value XE₂₀ is difficult to satisfy the above-described ranges.

From the above-described viewpoint, the thicknesses of the first electrode layer 24 and the second electrode layer 26 are preferably 3 µm or less, more preferably 2 µm or less, and still more preferably 1 µm or less. Further, the thicknesses of the first electrode layer 24 and the second electrode layer 26 are preferably 0.1 µm or greater, more preferably 0.2 µm or greater, and still more preferably 0.3 µm or greater.

Further, the wire from the power source is connected to the first electrode layer 24 and the second electrode layer 26, but in a case where the planar shape of the piezoelectric film is a square, it is preferable that the site where the first electrode layer 24 and the wire are connected to each other and the site where the second electrode layer 26 and the wire are connected to each other are provided on a long side from the viewpoint of shortening the length of the path through which the current flows. Further, it is also preferable that each electrode layer and the wire are connected to each other at a plurality of sites.

As described above, it is preferable that the piezoelectric film 10 has a configuration in which the piezoelectric layer 20 obtained by dispersing the piezoelectric particles 36 in the matrix 34 containing the polymer material that has a viscoelasticity at room temperature is sandwiched between the first electrode layer 24 and the second electrode layer 26 and this laminate is sandwiched between the first protective layer 28 and the second protective layer 30.

It is preferable that, in such a piezoelectric film 10, the maximal value of the loss tangent (tanδ) at a frequency of 1 Hz according to dynamic viscoelasticity measurement is present at room temperature and more preferable that the maximal value at which the loss tangent is 0.1 or greater is present at room temperature.

In this manner, even in a case where the piezoelectric film 10 is subjected to large bending deformation at a relatively slow vibration of less than or equal to a few Hz from the outside, since the strain energy can be effectively diffused to the outside as heat, occurrence of cracks at the interface between the polymer matrix and the piezoelectric particles can be prevented.

In the piezoelectric film 10, it is preferable that the storage elastic modulus (E') at a frequency of 1 Hz according to the dynamic viscoelasticity measurement is in a range of 10 to 30 GPa at 0°C and in a range of 1 to 10 GPa at 50°C.

In this manner, the piezoelectric film 10 may have large frequency dispersion in the storage elastic modulus (E') at room temperature. That is, the piezoelectric film 10 can exhibit a behavior of being rigid with respect to a vibration of 20 Hz to 20 kHz and being flexible with respect to a vibration of less than or equal to a few Hz.

In the piezoelectric film 10, it is preferable that the product of the thickness and the storage elastic modulus (E') at a frequency of 1 Hz according to the dynamic viscoelasticity measurement is in a range of 1.0 × 10⁶ to 2.0 × 10⁶ N/m at 0°C and in a range of 1.0 × 10⁵ to 1.0 × 10⁶ N/m at 50°C.

In this manner, the piezoelectric film 10 may have moderate rigidity and mechanical strength within a range not impairing the flexibility and the acoustic characteristics.

Further, in the piezoelectric film 10, it is preferable that the loss tangent (Tanδ) at a frequency of 1 kHz at 25°C is 0.05 or greater in a master curve obtained from the dynamic viscoelasticity measurement.

In this manner, the frequency of a speaker formed of the piezoelectric film 10 is smooth as the frequency characteristic thereof, and thus an amount of a change in acoustic quality in a case where the lowest resonance frequency f₀ is changed according to a change in the curvature of the speaker can be decreased.

Next, an example of the method of producing the piezoelectric film 10 will be described with reference to Figs. 4 to 6.

First, as illustrated in Fig. 4, a sheet-like material 10a in which the first electrode layer 24 is formed on the first protective layer 28 is prepared. The sheet-like material 10a may be prepared by forming a copper thin film or the like as the first electrode layer 24 on the surface of the first protective layer 28 by carrying out vacuum vapor deposition, sputtering, plating, or the like.

In a case where the first protective layer 28 is extremely thin and thus the handleability is degraded, the first protective layer 28 with a separator (temporary support) may be used as necessary. Further, a PET having a thickness of 25 µm to 100 µm or the like can be used as the separator. The separator may be removed after thermal compression bonding of the second electrode layer 26 and the second protective layer 30 and before lamination of any member on the first protective layer 28.

Meanwhile, the coating material is prepared by dissolving a polymer material serving as a material of the matrix in an organic solvent, adding the piezoelectric particles 36 such as PZT particles thereto, and stirring the solution for dispersion.

The organic solvent other than the above-described substances is not limited, and various organic solvents can be used.

In a case where the sheet-like material 10a is prepared and the coating material is prepared, the coating material is cast (applied) onto the sheet-like material 10a, and the organic solvent is evaporated and dried. In this manner, as illustrated in Fig. 5, a laminate 10b in which the first electrode layer 24 is provided on the first protective layer 28 and the piezoelectric layer 20 is formed on the first electrode layer 24 is prepared. Further, the first electrode layer 24 denotes an electrode on the base material side in a case where the piezoelectric layer 20 is coated with the layer, and does not denote the vertical positional relationship in the laminate.

A casting method of the coating material is not limited, and all known methods (coating devices) such as a slide coater or a doctor knife can be used.

As described above, in the piezoelectric film 10, in addition to the viscoelastic material such as cyanoethylated PVA, a dielectric polymer material may be added to the matrix 34.

In a case where the polymer material is added to the matrix 34, the polymer material added to the coating material may be dissolved.

In a case where the laminate 10b in which the first electrode layer 24 is provided on the first protective layer 28 and the piezoelectric layer 20 is formed on the first electrode layer 24 is prepared, it is preferable that the piezoelectric layer 20 is subjected to a polarization treatment (poling).

A method of performing the polarization treatment on the piezoelectric layer 20 is not limited, and a known method can be used.

Before the polarization treatment, a calender treatment may be performed to smoothen the surface of the piezoelectric layer 20 using a heating roller or the like. By performing the calender treatment, a thermal compression bonding step described below can be smoothly performed.

In this manner, while the piezoelectric layer 20 of the laminate 10b is subjected to the polarization treatment, a sheet-like material 10c in which the second electrode layer 26 is formed on the second protective layer 30 is prepared. The sheet-like material 10c may be prepared by forming a copper thin film or the like as the second electrode layer 26 on the surface of the second protective layer 30 using vacuum vapor deposition, sputtering, plating, or the like.

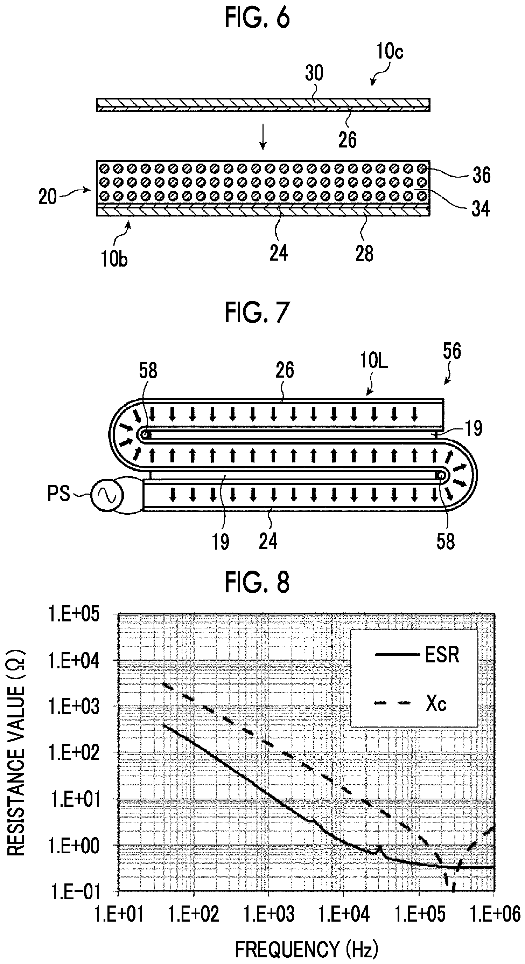

Next, as illustrated in Fig. 6, the sheet-like material 10c is laminated on the laminate 10b in which the polarization treatment performed on the piezoelectric layer 20 is completed in a state where the second electrode layer 26 is directed toward the piezoelectric layer 20.

Further, a laminate of the laminate 10b and the sheet-like material 10c is subjected to the thermal compression bonding using a heating press device, a heating roller pair, or the like and cut to have a desired shape such that the laminate of the laminate 10b and the sheet-like material 10c is sandwiched between the second protective layer 30 and the first protective layer 28, thereby preparing the piezoelectric film 10.

Further, the steps described so far can also be performed by using a web-like material, that is, a material wound up in a state where long sheets are connected without using a sheet-like material, during transport. Both the laminate 10b and the sheet-like material 10c have a web shape and can be subjected to thermal compression bonding as described above. In that case, the piezoelectric film 10 is prepared in a web shape at this time point.

Further, a special glue layer may be provided in a case where the laminate 10b and the sheet-like material 10c are bonded to each other. For example, the glue layer may be provided on the surface of the second electrode layer 26 of the sheet-like material 10c. The most suitable glue layer is made of the same material as the matrix 34. The surface of the second electrode layer 26 can be coated with the same material as described above so that the laminate and the sheet-like material can be bonded to each other.

### [Other embodiments of laminated piezoelectric element]

Here, in the example illustrated in Fig. 1, the laminated piezoelectric element 50 has a configuration in which a plurality of sheets of the piezoelectric films 10 are laminated (hereinafter, also referred to as a sheet type laminated piezoelectric element), but the laminated piezoelectric element according to the embodiment of the present invention is not limited thereto, and various configurations can be used.

Fig. 7 illustrates an example thereof. Since the laminated piezoelectric element 56 illustrated in Fig. 7 uses a plurality of the same members as those of the laminated piezoelectric element 50 described above, the same members are denoted by the same reference numerals, and the description will be given mainly to different parts.

The laminated piezoelectric element 56 illustrated in Fig. 7 is formed by laminating a plurality of layers of the piezoelectric film in a layered manner by folding back a long piezoelectric film 10L once or more times and preferably a plurality of times in the longitudinal direction. In addition, similarly to the laminated piezoelectric element 50 illustrated in Fig. 1 described above, in the piezoelectric element 56 illustrated in Fig. 7 is formed by bonding the piezoelectric film laminated by folding-back with the adhesive layer 19 as a preferred embodiment.

By folding back and laminating one sheet of the long piezoelectric film 10L polarized in the thickness direction, the polarization directions of the piezoelectric film adjacent (facing) in the lamination direction are opposite directions as indicated by the arrows in Fig. 7.

Further, the first protective layer 28 and the second protective layer 30 of the piezoelectric film 10L are not illustrated in Fig. 7, but the piezoelectric film 10L may include the first protective layer 28 and the second protective layer 30.

According to this configuration, the laminated piezoelectric element 56 can be configured with only one long piezoelectric film 10L, only one power source PS for applying the driving voltage is required, and an electrode may be led out from the piezoelectric film 10L at one place.

Therefore, according to the laminated piezoelectric element 56 illustrated in Fig. 7, the number of components can be reduced, the configuration can be simplified, the reliability of the piezoelectric element (module) can be improved, and a further reduction in cost can be achieved.

However, in such a structure in which one long piezoelectric film 10L is folded back (hereinafter, also referred to as a bellows type piezoelectric element), the length of the path through which the current flows is likely to be increased, and connection of the plurality of piezoelectric films in parallel as in the sheet type laminated piezoelectric element cannot be made. Therefore, the sheet type laminated piezoelectric element is preferable from the viewpoint that the value XE₂₀ satisfies the above-described ranges.

Similar to the piezoelectric element 56 illustrated in Fig. 7, in the piezoelectric element 56 in which the long piezoelectric film 10L is folded back, it is preferable that a core rod 58 is brought into contact with the piezoelectric film 10L and inserted into the folded-back portion of the piezoelectric film 10L.

As described above, the first electrode layer 24 and the second electrode layer 26 of the piezoelectric film 10L are formed of a metal vapor deposition film or the like. In a case where the metal vapor deposition film is bent at an acute angle, cracks and the like are likely to occur, and thus the electrode may be broken. That is, in the piezoelectric element 56 illustrated in Fig. 7, cracks and the like are likely to occur in the electrodes inside the bent portion.

For this, in the piezoelectric element 56 in which the long piezoelectric film 10L is folded back, by inserting the core rod 58 into the folded-back portion of the piezoelectric film 10L, the first electrode layer 24 and the second electrode layer 26 are prevented from being bent. Therefore, the occurrence of breakage can be suitably prevented.

### <Adhesive layer>

The adhesive layer 19 for bonding the piezoelectric films 10 to each other and the adhesive layer 16 for bonding the laminated piezoelectric element 50 and the vibration plate 12 are not limited, and various known pressure sensitive adhesives and adhesives can be used.

Various known adhesive layers can be used as long as the adhesive layers are capable of bonding members to each other.

Therefore, the adhesive layer may be a layer consisting of an adhesive, which has fluidity during bonding and thereafter enters a solid state, a layer consisting of a pressure sensitive adhesive, which is a gel-like (rubber-like) flexible solid during bonding and does not change in the gel-like state thereafter, or a layer consisting of a material having characteristics of both an adhesive and a pressure sensitive adhesive.

Here, the laminated piezoelectric element 50 according to the embodiment of the present invention generates a sound by allowing a plurality of sheets of the laminated piezoelectric films 10 to be stretched and contracted to vibrate the vibration plate 12. Accordingly, it is preferable that the stretching and contraction of each piezoelectric film 10 is directly transmitted. In a case where a substance having a viscosity that relaxes vibration is present between the piezoelectric films 10, the efficiency of transmitting the stretching and contracting energy of the piezoelectric films 10 is lowered, and the driving efficiency of the piezoelectric films 10 is also degraded.

In consideration of this point, it is preferable that the adhesive layer is an adhesive layer consisting of an adhesive from which a solid and hard adhesive layer is obtained, rather than a pressure sensitive adhesive layer consisting of a pressure sensitive adhesive. As a more preferable adhesive layer, specifically, a bonding layer consisting of a thermoplastic type adhesive such as a polyester-based adhesive or a styrene-butadiene rubber (SBR)-based adhesive is suitably exemplified.

Adhesion, which is different from pressure sensitive adhesion, is useful in a case where a high adhesion temperature is required. Further, the thermoplastic type adhesive has characteristics of "a relatively low temperature, a short time, and strong adhesion", which is suitable.

The thickness of the adhesive layer is not limited, and a thickness that enables a sufficient bonding force to be exhibited may be appropriately set according to the material for forming the adhesive layer.

Here, in a case where the adhesive layer of the laminated piezoelectric element 50 according to the embodiment of the present invention is thin, the effect of transmitting the stretching and contracting energy (vibration energy) of the piezoelectric layer 20 increases, and the energy efficiency increases. In addition, in a case where the adhesive layer is thick and has high rigidity, there is also a possibility that the stretching and contracting of the piezoelectric film may be constrained. Further, in a case of the configuration in which the adjacent piezoelectric films 10 are laminated such that the polarization directions are opposite to each other as illustrated in Fig. 1, there is no risk of a short circuit between the adjacent piezoelectric films 10, and thus the thickness of the adhesive layer can be reduced.

In consideration of this point, it is preferable that the adhesive layer is thinner than the piezoelectric layer 20. That is, it is preferable that the adhesive layer in the laminated piezoelectric element 50 according to the embodiment of the present invention is hard and thin.

Specifically, the thickness of the adhesive layer is preferably in a range of 0.1 to 50 µm, more preferably in a range of 0.1 to 30 µm, and still more preferably in a range of 0.1 to 10 µm in terms of thickness after the bonding.

In the laminated piezoelectric element 50 according to the embodiment of the present invention, in a case where the spring constant of the adhesive layer is high, there is a possibility that the stretching and contracting of the piezoelectric film 10 may be constrained. Therefore, it is preferable that the spring constant of the adhesive layer is less than or equal to the spring constant of the piezoelectric film 10. Further, the spring constant is obtained by "thickness × Young's modulus".

Specifically, the product of the thickness of the adhesive layer and the storage elastic modulus (E') at a frequency of 1 Hz according to the dynamic viscoelasticity measurement is preferably 2.0 × 10⁶ N/m or less at 0°C and 1.0 × 10⁶ N/m or less at 50°C.

Further, it is preferable that the internal loss of the adhesive layer at a frequency of 1 Hz according to the dynamic viscoelasticity measurement is 1.0 or less at 25°C in the case of the adhesive layer consisting of a pressure sensitive adhesive and is 0.1 or less at 25°C in the case of the adhesive layer consisting of an adhesive.

### <Vibration plate>

The vibration plate 12 is not limited, and various articles can be used.

Examples of the vibration plate 12 include plate materials such as plates made of resins and glass plates, advertisement/notice media such as signboards, office equipment and furniture such as tables, whiteboards, and projection screens, display devices such as organic electroluminescence (organic light emitting diode (OLED)) displays and liquid crystal displays, vehicle members such as consoles, A-pillars, ceilings, and bumpers such as automobiles, and building materials such as walls of houses.

The vibration plate 12 to which the laminated piezoelectric element 50 according to the embodiment of the present invention is bonded is preferably flexible and more preferably windable.

As the vibration plate 12 having flexibility, a panel-like display device having flexibility such as a flexible display panel is particularly suitably exemplified. Moreover, it is more preferable that the display device can be also wound.

Here, in order to prevent the laminated piezoelectric element 50 from being peeled off from the vibration plate 12 in a case where the vibration plate 12 is wound, it is preferable that the laminated piezoelectric element 50 is bent with the vibration plate 12 according to the curvature of the winding of the vibration plate 12. Further, since the piezoelectric film 10 has suitable flexibility, the laminated piezoelectric element 50 according to the embodiment of the present invention also basically exhibits satisfactory flexibility.

In this case, the curvature of winding of the vibration plate 12 is basically a specific curvature, but the curvature of winding of the vibration plate 12 may be variable.

In the present invention, in a case where a display device is used as the vibration plate 12, it is preferable that the laminated piezoelectric element 50 is bonded to a rear surface side of the display device, that is, a non-image display surface side of the display device.

In this case, it is preferable that the size of the adhesive layer 16 in the plane direction is the same as or smaller than the size of the planar shape of the laminated piezoelectric element 50.

Further, in a case where a display device is used as the vibration plate 12, a display device such as a flexible display panel may be used as the vibration plate 12, or a plate-like member provided in a display device or a plate-like member engaged with a display device may be used as the vibration plate 12.

In a case where the vibration plate 12 can be wound, it is preferable that a driving current is energized to the piezoelectric film 10 in a state where the vibration plate 12 is not wound and that the piezoelectric film 10 is not energized in a case where the vibration plate 12 is wound.

Further, it is preferable that a driving current is energized to the piezoelectric film 10 and/or the vibration plate 12 in a state where the vibration plate 12 is not wound in a case where the vibration plate 12 is electrically driven similarly to a display device and that the piezoelectric film 10 and/or the vibration plate 12 is not energized in a case where the vibration plate 12 is wound.

As a method of switching between energization and de-energization, various known methods can be used.

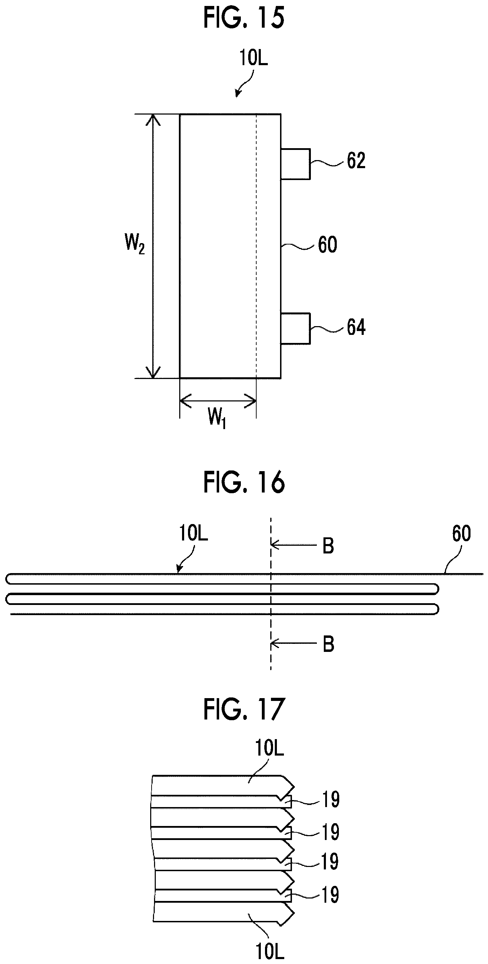

Here, from the viewpoint of increasing the sound pressure in a wide frequency band, a square shape (rectangular shape) is preferable as the planar shape of the laminated piezoelectric element (see Fig. 15). Further, in a case where the planar shape of the laminated piezoelectric element is a square, the sound pressure at the same applied voltage can be further increased by further increasing a length W₂ of the long side without changing a length W₁ of the short side. Therefore, the voltage for obtaining the same sound pressure can be further decreased, and the amount of heat generation can be suppressed.

Fig. 15 is a plan view illustrating an example of a laminated piezoelectric element having a square shape. Fig. 16 is a side view of Fig. 15 as viewed from the short side. In Fig. 16, the adhesive layer and the lead-out portion of the electrode are not illustrated. The example illustrated in Figs. 15 and 16 is an example in which the long piezoelectric film 10L is folded back a plurality of times to form a laminate. In the example illustrated in Figs. 15 and 16, the direction in which the piezoelectric film is folded back a plurality of times is the short side direction.

Further, in the example illustrated in Figs. 15 and 16, the piezoelectric film is folded back such that the lengths of the short sides of the folded-back and laminated regions are the same as each other, but only the layer of the outermost surface is formed to have a projecting portion 60 whose end portion protrudes from the laminated portion. As illustrated in Fig. 15, lead-out portions (62, 64) of the electrodes are provided in the periphery of both end portions of the projecting portion 60 in the long side direction.

As described above, a configuration in which the amount of heat generation is suppressed may be combined with the laminated piezoelectric element according to the embodiment of the present invention by forming the planar shape of the laminated piezoelectric element into a square shape and further increasing the length W₂ of the long side without changing the length W₁ of the short side.

From the viewpoint of suppressing the amount of heat generation while maintaining the sound pressure level, the ratio of the length W₂ of the long side to the length W₁ of the short side is preferably in a range of 3 to 30, more preferably in a range of 3 to 20, and still more preferably in a range of 3 to 10.

Here, in the laminated piezoelectric element having a square shape, the production process for the laminated piezoelectric element in which the lengths of the short sides are the same as each other and the lengths of the long sides are different from each other can be further simplified by preparing a laminate of the piezoelectric film with longer long sides and cutting the film as necessary. For example, a laminated piezoelectric element having a long side of 20 cm and a short side of 3 cm and a laminated piezoelectric element having a long side of 26 cm and a short side of 3 cm can be prepared by preparing a laminate of a piezoelectric film having a long side of 46 cm and a short side of 3 cm and cutting the laminate at a position separated from one short side by 20 cm.

As illustrated in Fig. 16, Fig. 17 is an enlarged view of a part of the cross section taken along line B-B in a case where the long piezoelectric film 10L is folded back a plurality of times to form a laminate and cut in parallel with the paper surface.

In a case where the piezoelectric film 10L is laminated and cut, as illustrated in Fig. 17, an end portion of each layer of the piezoelectric film 10L on the short side is deformed in the same direction. In the illustrated example, the end portion of each layer is deformed downward. In this manner, since the cut end portions of the respective layers are deformed in the same direction, it is possible to prevent the electrode layers between the respective layers from coming into contact with each other to cause a short circuit. Further, since the adhesive layer 19 is provided between the respective layers, the adhesive layer serves as an insulator, and thus it is possible to prevent the electrode layers between the respective layers from coming into contact with each other to cause a short circuit.

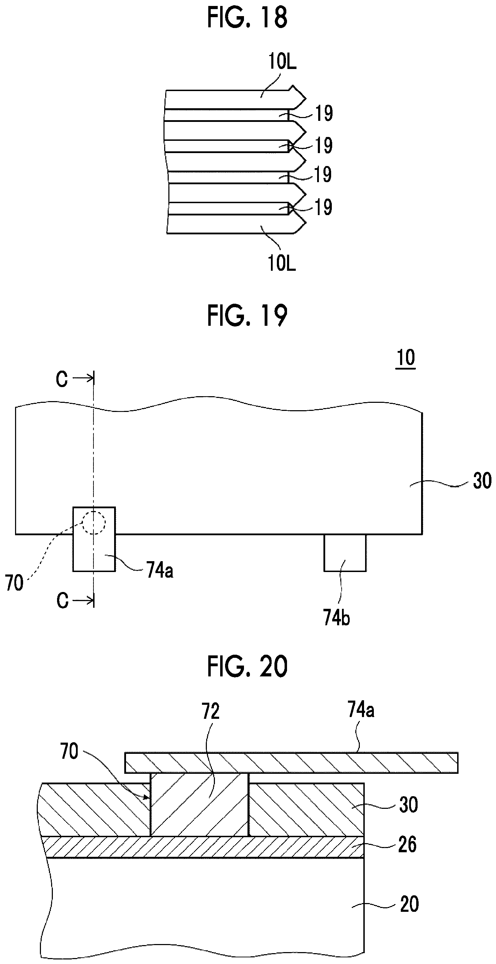

In the present invention, the long piezoelectric film 10L is cut, and the cut piezoelectric film 10L may be folded back a plurality of times and laminated. In this case, as illustrated in Fig. 18, the end portion of each layer of the piezoelectric film 10L on the short side is deformed in a direction opposite to that of an adjacent layer. In the configuration in which the piezoelectric film 10L is folded back a plurality of times and laminated, since the facing electrode layers of the adjacent layers are connected to each other, the contact between the layers is not problematic. Further, since the electrode layers with different polarities are difficult to come into contact with each other, occurrence of a short circuit can be prevented.

In the present invention, a method of connecting the electrode layer of the piezoelectric film to the wire is not particularly limited, and the connection can be made by various known methods. For example, a portion where the electrode layer and the protective layer protrude outward from the piezoelectric layer in the plane direction may be provided, and the wire may be connected to the electrode layer of the protruding portion. Alternatively, as in the example illustrated in Figs. 19 and 20, a part of the protective layer (second protective layer 30 in Fig. 20) is removed to form a hole portion 70, a conductive member 72 such as silver paste or the like is disposed in the hole portion 70 so that the conductive member 72 and the electrode layer (second electrode layer 26 in Fig. 20) are electrically conductive to each other, and the wire (conductive wire 74a) may be connected to the electrode layer (second electrode layer 26) via the conductive member 72.

In a case of the sheet type laminated piezoelectric element, it is preferable that the protective layer is disposed on the electrode layer on the outermost layer side of at least the piezoelectric film disposed on the outermost layer of the laminated piezoelectric element. Further, all the piezoelectric films of the sheet type laminated piezoelectric element may include a protective layer.

Here, in the laminated piezoelectric element according to the embodiment of the present invention, in a case where at least one piezoelectric film has a configuration in which the protective layer has a hole portion penetrating from the surface to the electrode layer, and the conductive member is disposed in the hole portion (the hole portion is filled with a conductive member) so that the conductive wire (wire) is electrically connected to the electrode layer via the conductive member, C/(A × t) is preferably 260 µF/mm³ or less in a case where the opening area of the hole portion is defined as A, the thickness of the electrode layer is defined as t, and the capacitance of the laminated piezoelectric element is defined as C.

In a case of the configuration in which the hole portion is provided in the protective layer and the conductive member is disposed in the hole portion so that the conductive wire and the electrode layer are connected to each other via the conductive member, since the entire current applied to the laminated piezoelectric element flows into the conductive member, the conductive member and the portion of the electrode layer in contact with the conductive member (hereinafter, also referred to as an electrode contact portion) are likely to generate heat due to the current concentration. Therefore, there may be a problem that the temperature of the laminated piezoelectric element is increased in a case where the laminated piezoelectric element is continuously driven.

On the contrary, the current density at the electrode contact portion can be reduced and local heat generation at the electrode contact portion can be suppressed by setting C/(A × t) to 260 µF/mm³ or less, that is, by decreasing the capacitance of the laminated piezoelectric element and/or by increasing the volume of the electrode layer in the electrode contact portion.

From the viewpoint of suppressing heat generation, C/(A × t) is more preferably 260 µF/mm³ or less and still more preferably 150 µF/mm³ or less. Further, from the viewpoint of the productivity, C/(A × t) is preferably 50 µF/mm³ or greater.

Here, the capacitance C of the laminated piezoelectric element may be measured by using an LCR meter (for example, ZM2372, manufactured by NF HOLDINGS CORPORATION) between the wires led out from the respective electrode layers of the piezoelectric film constituting the laminated piezoelectric element. The measurement is carried out at a measurement frequency of 1 kHz and a voltage of 5 V.

In a case of the sheet type laminated piezoelectric element, the capacitance C of the laminated piezoelectric element may be measured in a state where two electrode layers having the same polarity of each piezoelectric film are connected to each other, that is, a plurality of piezoelectric films are connected in parallel.

Further, the capacitance C of the piezoelectric film is determined according to the thickness of the piezoelectric layer, the area of the piezoelectric layer, and the relative dielectric constant of the piezoelectric layer. Therefore, the capacitance C of the piezoelectric film can be adjusted by adjusting these.

In addition, the opening area A (area in plan view) of the hole portion can be measured by measuring the hole portion of the protective layer exposed by removing the conductive wire with a CNC image measuring device (for example, Quick Vision, manufactured by Mitutoyo Corporation). In a case where the contour of the hole portion is not seen, the conductive member may be removed. In this case, it is necessary to select a method that does not damage the protective layer.

From the viewpoint of decreasing C/(A × t), it is preferable that the opening area A of the hole portion is large. However, in a case where the opening area A of the hole portion is extremely large, there is a disadvantage in terms of the productivity.

In addition, the shape of the opening portion (the shape in plan view) of the hole portion is not limited, and examples thereof include various shapes such as a circular shape, an elliptical shape, a square shape, a polygonal shape, and an indeterminate shape. From the viewpoints of ease of formation and the like, a circular shape is preferable.

A method of forming the hole portion is not limited, and a known method may be used depending on the material for forming the protective layer. Examples of the method of forming the hole portion include methods such as laser processing, dissolution removal using a solvent, and mechanical processing such as mechanical polishing.

The thickness of the electrode layer can be measured by cutting a piezoelectric film using an ultramicrotome (for example, UC6, manufactured by Leica Microsystems) and observing a cross section using an SEM (for example, SU8220, manufactured by Hitachi High-Tech Corporation).

As the conductive member, conductive paste such as silver paste, solder, a conductive cloth, a metal cloth, conductive urethane foam, or the like can be used.

As the conductive paste, a material containing silver, copper, gold, carbon, nickel, solder, or the like as a filler is used. The hole portion may be filled with the conductive paste using a dispenser or the like. Further, it is preferable that the hole portion is filled with the conductive paste to be filled with a sufficient amount of the conductive paste. It is more preferable that the hole portion is filled with the conductive paste in an amount that the conductive paste rises from the hole portion or the conductive paste overflows from the hole portion.

The conductive cloth is, for example, a nonwoven fabric or a woven fabric woven with a thread obtained by coating the surface of a resin thread with a metal film by plating or the like. As the conductive cloth, various known conductive cloths can be used. Examples of the conductive cloth include a conductive cloth in which the surface of a thread consisting of PET is Cu-plated or Ni-plated. Specifically, Sui-10-511M (manufactured by Seiren Co., Ltd.) can be used as the conductive cloth.

The metal cloth is a woven fabric woven with a metal thread or a non-woven fabric. As the metal cloth, various known metal cloths can be used. As an example, a plain-woven wire mesh having a diameter of Φ0.05 × 200 m/s (manufactured by Okutani Ltd.) can be used as the metal cloth.

The conductive urethane foam is formed by carrying conductive particles such as carbon black on soft urethane foam. As the conductive urethane foam, various known conductive urethane foams can be used.

In addition, the thickness of the conductive member is preferably greater than the thickness of the protective layer. In this manner, the conductive member and the conductive wire can be reliably connected to each other.

As the conductive wire, a sheet-like material (metal foil) or a wire-like material (metal wire) formed of a conductive metal material can be used. Suitable examples of the material of the conductive wire include copper, aluminum, nickel, tin, gold, and silver. In addition, an FFC cable may be used as the conductive wire.

The shape and size of the conductive wire are not particularly limited. The shape and size of the conductive wire are not limited as long as the conductive wire can be electrically connected to the conductive member and can be used as a lead-out electrode.

In addition, the conductive wire and the conductive member may be connected to each other by a known method. In a case where the conductive member is a conductive paste, the conductive wire and the conductive member may be connected to each other by bringing the conductive wire and the conductive member into contact with each other and curing the conductive paste. Alternatively, the conductive wire and the conductive member may be connected to each other by covering at least a part of the contact portion and bonding bonding tape onto the protective layer in a state where the conductive wire and the conductive member are in contact with each other. Alternatively, the connection between the conductive wire and the conductive member may be fixed by bonding the conductive wire and the protective layer in a state where the conductive wire and the conductive member are in contact with each other.

Hereinbefore, the laminated piezoelectric element according to the embodiment of the present invention has been described in detail, but the present invention is not limited to the above-described examples, and various improvements or modifications may be made within a range not departing from the scope of the present invention.

### Examples

Hereinafter, the present invention will be described in more detail with reference to specific examples of the present invention. Further, the present invention is not limited to the examples, and the materials, the used amounts, the proportions, the treatment contents, the treatment procedures, and the like shown in the following examples can be appropriately changed within a range not departing from the scope of the present invention.

### [Example 1]

Sheet-like materials 10a and 10c formed by sputtering a copper thin film having a thickness of 100 nm on a PET film having a thickness of 4 µm were prepared. That is, in the present example, the first electrode layer 24 and the second electrode layer 26 were copper thin films having a thickness of 100 nm, and the first protective layer 28 and the second protective layer 30 were PET films having a thickness of 4 µm.

The gas pressure during the sputtering of the copper thin film on the PET film was set to 0.4 Pa, and the base material temperature (temperature of the PET film) was set to 120°C. In the columns of the method of forming the electrode layer in Table 1, a case where the sputtering was performed under the same conditions as in Example 1 is listed as "sputtering 1".

Further, in order to obtain satisfactory handleability during the process, a film with a separator (temporary support PET) having a thickness of 50 µm was used as the PET film, and the separator of each protective layer was removed after the thermal compression bonding of the sheet-like material 10c.

First, cyanoethylated PVA (CR-V, manufactured by Shin-Etsu Chemical Co., Ltd.) was dissolved in methyl ethyl ketone (MEK) at the following compositional ratio. Thereafter, PZT particles were added to the solution at the following compositional ratio and dispersed using a propeller mixer (rotation speed of 2000 rpm), thereby preparing a coating material for forming a piezoelectric layer 20.
- PZT Particles: 300 parts by mass
- Cyanoethylated PVA: 15 parts by mass
- MEK: 85 parts by mass

In addition, PZT particles obtained by sintering commercially available PZT raw material powder at 1000°C to 1200°C and crushing and classifying the sintered powder to have an average particle diameter of 5 µm were used as the PZT particles.

The first electrode layer 24 (copper thin film) of the sheet-like material 10a prepared in advance was coated with the coating material for forming the piezoelectric layer 20 prepared in advance using a slide coater. Further, the coating material was applied such that the film thickness of the coating film after being dried reached 20 µm.

Next, a material obtained by coating the sheet-like material 10a with the coating material was heated and dried on a hot plate at 120°C to evaporate MEK, thereby forming a laminate 10b.

The sheet-like material 10c was laminated on the laminate 10b in a state where the second electrode layer 26 (copper thin film side) side faced the piezoelectric layer 20, and subjected to thermal compression bonding at 120°C.

In this manner, a piezoelectric film 10 including the first protective layer 28, the first electrode layer 24, the piezoelectric layer 20, the second electrode layer 26, and the second protective layer 30 in this order was prepared.

The prepared piezoelectric film was cut into a size of 200 mm × 190 mm in plan view and folded back four times in the longitudinal direction to prepare a bellows type piezoelectric element 56. The surfaces in contact with each other by folding back the film were bonded to each other using a thermal adhesive sheet (FB-ML4, manufactured by Nitto Shinko Corporation).

In addition, the first electrode layer 24 and the wire were connected to each other on one end side of the long side of the folded-back piezoelectric film, and the second electrode layer 26 and the wire were connected to each other on the other end side thereof as described below.

A laser processing machine was used for each of the first protective layer and the second protective layer to form a hole portion. The opening shape of the hole portion was circular, and the opening area thereof was set to 60 mm². Conductive paste containing a Ni filler was used as the conductive member, and a copper foil having a thickness of 35 µm was used as the wire (conductive wire). The hole portion was filled with the conductive paste using a dispenser, the wire was brought into contact with the conductive paste, and the conductive paste was dried and cured.

The capacitive reactance Xc and the equivalent series resistance ESR of the prepared piezoelectric element were measured by the method described above. Fig. 8 is a graph of the measured frequency and the resistance value. With reference to Fig. 8, the capacitive reactance Xc at 1 kHz was 148 Ω, and the equivalent series resistance ESR was 12.2 S2. Therefore, the ratio Xc/ESR of the capacitive reactance Xc to the equivalent series resistance ESR was 12.1. Further, the capacitive reactance Xc at 20 kHz was 8.29 Ω, and the equivalent series resistance ESR was 0.77 Ω. Therefore, the ratio Xc/ESR of the capacitive reactance Xc to the equivalent series resistance ESR was 10.8. The ratio Xc/ESR at 20 kHz in a case where the ratio Xc/ESR at 1 kHz was set to 1, that is, XE₂₀ was 0.89.

Further, the capacitance between the wire connected to the first electrode layer 24 and the wire connected to the second electrode layer 26 of the prepared laminated piezoelectric element was measured by an LCR meter (for example, ZM2372, manufactured by NF HOLDINGS CORPORATION), and the value was 1.2 µF. Therefore, C/(A × t) obtained by dividing the capacitance C by the opening area A of the hole portion and the thickness t of the electrode layer was 200.0 µF/mm³.

### [Example 2]

A piezoelectric film was prepared in the same manner as in Example 1 except that the thicknesses of the first electrode layer 24 and the second electrode layer 26 (copper thin film) were set to 150 nm.

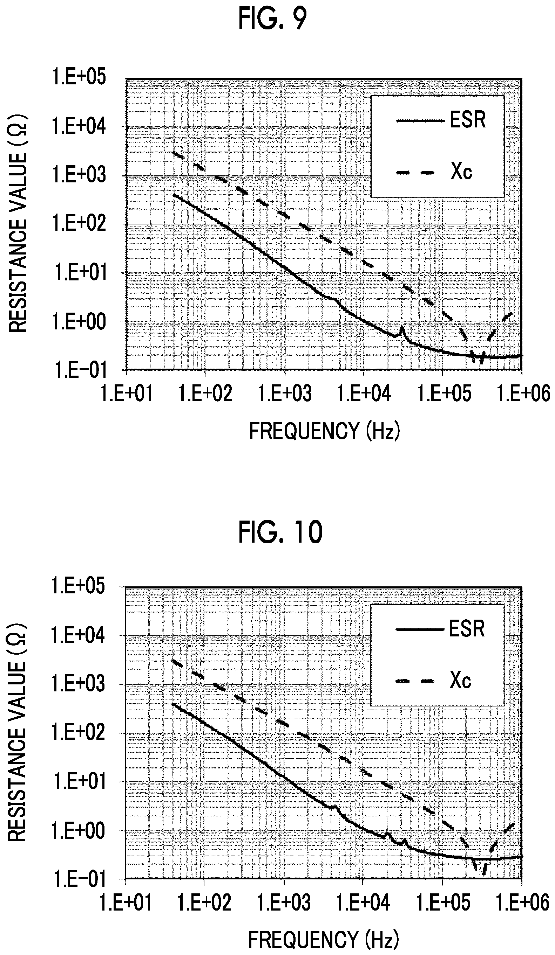

The capacitive reactance Xc and the equivalent series resistance ESR of the prepared piezoelectric element were measured by the method described above. Fig. 9 is a graph of the measured frequency and the measured resistance value. With reference to Fig. 9, the capacitive reactance Xc at 1 kHz was 149 Ω, and the equivalent series resistance ESR was 12.3 S2. Therefore, the ratio Xc/ESR of the capacitive reactance Xc to the equivalent series resistance ESR was 12.1. Further, the capacitive reactance Xc at 20 kHz was 8.32 Ω, and the equivalent series resistance ESR was 0.58 Ω. Therefore, the ratio Xc/ESR of the capacitive reactance Xc to the equivalent series resistance ESR was 14.3. The ratio Xc/ESR at 20 kHz in a case where the ratio Xc/ESR at 1 kHz was set to 1, that is, XE₂₀ was 1.18.

In addition, the capacitance of the prepared laminated piezoelectric element was 1.2 µF. C/(A × t) was 133.3 µF/mm³.

### [Example 3]

The piezoelectric film 10 prepared in Example 1 was cut into five sheets of films with a size of 200 mm × 38 mm in plan view, and the cut-out five piezoelectric films 10 were laminated to prepare a sheet type piezoelectric element 50. The adjacent piezoelectric films 10 were bonded to each other using a thermal adhesive sheet (FB-ML4, manufactured by Nitto Shinko Corporation).

In addition, the first electrode layer 24 and the wire were connected to each other on one side of both sides with a length of 200 mm of each piezoelectric film 10 in the width direction, and the second electrode layer 26 and the wire were connected to each other on the other side thereof. That is, the first electrode layer 24 and the wire and the second electrode layer 26 and the wire of each piezoelectric film 10 were connected at two sites. Further, the piezoelectric films 10 were connected in parallel.

The capacitive reactance Xc and the equivalent series resistance ESR of the prepared piezoelectric element were measured by the method described above. Fig. 10 is a graph of the measured frequency and the measured resistance value. With reference to Fig. 10, the capacitive reactance Xc at 1 kHz was 150 Ω, and the equivalent series resistance ESR was 12.1 S2. Therefore, the ratio Xc/ESR of the capacitive reactance Xc to the equivalent series resistance ESR was 12.1. Further, the capacitive reactance Xc at 20 kHz was 8.37 Ω, and the equivalent series resistance ESR was 0.70 Ω. Therefore, the ratio Xc/ESR of the capacitive reactance Xc to the equivalent series resistance ESR was 12.0. The ratio Xc/ESR at 20 kHz in a case where the ratio Xc/ESR at 1 kHz was set to 1, that is, XE₂₀ was 0.99.

In addition, the capacitance of the prepared laminated piezoelectric element was 1.2 µF. C/(A × t) was 200.0 µF/mm³.

### [Example 4]

A sheet type piezoelectric element 50 was prepared in the same manner as in Example 3 except that a copper thin film was formed by ion-assisted vapor deposition and the thickness of the film was set to 150 nm.

As an ion gun in a case where the copper thin film was subjected to ion-assisted vapor deposition on a PET film, ST55 (1500W, 7A, 225eV) (manufactured by TELEMARK) was used.

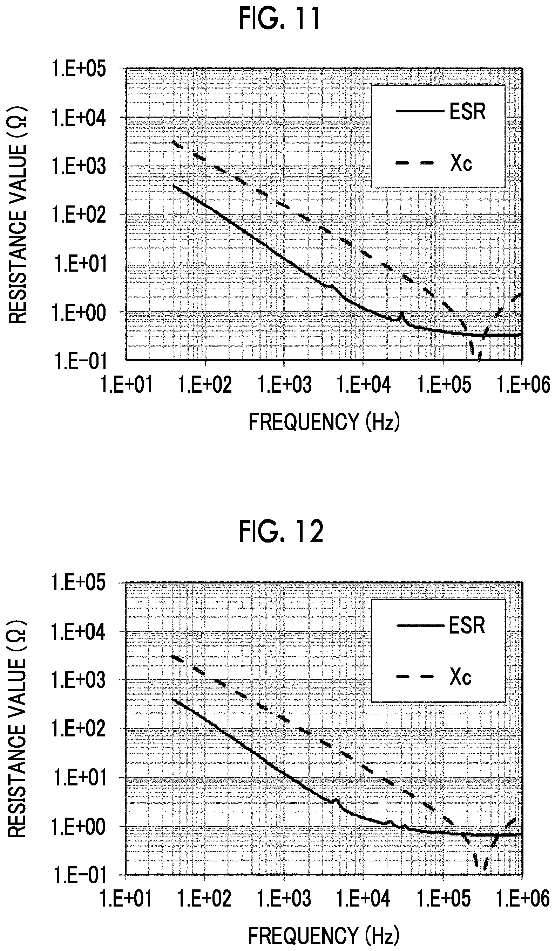

The capacitive reactance Xc and the equivalent series resistance ESR of the prepared piezoelectric element were measured by the method described above. Fig. 11 is a graph of the measured frequency and the measured resistance value. With reference to Fig. 11, the capacitive reactance Xc at 1 kHz was 148 Ω, and the equivalent series resistance ESR was 12.1. Therefore, the ratio Xc/ESR of the capacitive reactance Xc to the equivalent series resistance ESR was 12.2. Further, the capacitive reactance Xc at 20 kHz was 8.28 Ω, and the equivalent series resistance ESR was 0.73 Ω. Therefore, the ratio Xc/ESR of the capacitive reactance Xc to the equivalent series resistance ESR was 11.4. The ratio Xc/ESR at 20 kHz in a case where the ratio Xc/ESR at 1 kHz was set to 1, that is, XE₂₀ was 0.93.

In addition, the capacitance of the prepared laminated piezoelectric element was 1.2 µF. C/(A × t) was 133.3 µF/mm³.

### [Example 5]

A bellows type piezoelectric element was prepared in the same manner as in Example 2 except that the opening area A of the hole portion was set to 40 mm².

The capacitive reactance Xc and the equivalent series resistance ESR of the prepared piezoelectric element were measured by the method described above. The capacitive reactance Xc at 1 kHz was 147 Ω, and the equivalent series resistance ESR was 12.9 Ω. Therefore, the ratio Xc/ESR of the capacitive reactance Xc to the equivalent series resistance ESR was 11.4. Further, the capacitive reactance Xc at 20 kHz was 8.36 Ω, and the equivalent series resistance ESR was 0.68 Ω. Therefore, the ratio Xc/ESR of the capacitive reactance Xc to the equivalent series resistance ESR was 12.3. The ratio Xc/ESR at 20 kHz in a case where the ratio Xc/ESR at 1 kHz was set to 1, that is, XE₂₀ was 1.08.

In addition, the capacitance of the prepared laminated piezoelectric element was 1.2 µF. C/(A × t) was 200.0 µF/mm³.

### [Example 6]

A piezoelectric film was prepared in the same manner as in Example 1 except that the thicknesses of the first electrode layer 24 and the second electrode layer 26 (copper thin film) were set to 300 nm and the opening area A of the hole portion was set to 20 mm².

The capacitive reactance Xc and the equivalent series resistance ESR of the prepared piezoelectric element were measured by the method described above. The capacitive reactance Xc at 1 kHz was 145 Ω, and the equivalent series resistance ESR was 10.2 S2. Therefore, the ratio Xc/ESR of the capacitive reactance Xc to the equivalent series resistance ESR was 14.2. Further, the capacitive reactance Xc at 20 kHz was 8.44 Ω, and the equivalent series resistance ESR was 0.49 Ω. Therefore, the ratio Xc/ESR of the capacitive reactance Xc to the equivalent series resistance ESR was 17.2. The ratio Xc/ESR at 20 kHz in a case where the ratio Xc/ESR at 1 kHz was set to 1, that is, XE₂₀ was 1.21.

In addition, the capacitance of the prepared laminated piezoelectric element was 1.2 µF. C/(A × t) was 200.0 µF/mm³.

### [Example 7]

A piezoelectric film was prepared in the same manner as in Example 6 except that the opening area A of the hole portion was set to 30 mm².

The capacitive reactance Xc and the equivalent series resistance ESR of the prepared piezoelectric element were measured by the method described above. The capacitive reactance Xc at 1 kHz was 145 Ω, and the equivalent series resistance ESR was 10.0 S2. Therefore, the ratio Xc/ESR of the capacitive reactance Xc to the equivalent series resistance ESR was 14.5. Further, the capacitive reactance Xc at 20 kHz was 8.43 Ω, and the equivalent series resistance ESR was 0.44 Ω. Therefore, the ratio Xc/ESR of the capacitive reactance Xc to the equivalent series resistance ESR was 19.2. The ratio Xc/ESR at 20 kHz in a case where the ratio Xc/ESR at 1 kHz was set to 1, that is, XE₂₀ was 1.33.

In addition, the capacitance of the prepared laminated piezoelectric element was 1.2 µF. C/(A × t) was 133.3 µF/mm³.

### [Example 8]

A piezoelectric film was prepared in the same manner as in Example 6 except that the opening area A of the hole portion was set to 15 mm².

The capacitive reactance Xc and the equivalent series resistance ESR of the prepared piezoelectric element were measured by the method described above. The capacitive reactance Xc at 1 kHz was 146 Ω, and the equivalent series resistance ESR was 10.4 S2. Therefore, the ratio Xc/ESR of the capacitive reactance Xc to the equivalent series resistance ESR was 14.0. Further, the capacitive reactance Xc at 20 kHz was 8.46 Ω, and the equivalent series resistance ESR was 0.54 Ω. Therefore, the ratio Xc/ESR of the capacitive reactance Xc to the equivalent series resistance ESR was 15.7. The ratio Xc/ESR at 20 kHz in a case where the ratio Xc/ESR at 1 kHz was set to 1, that is, XE₂₀ was 1.12.

In addition, the capacitance of the prepared laminated piezoelectric element was 1.2 µF. C/(A × t) was 266.6 µF/mm³.

### [Comparative Example 1]

A bellows type piezoelectric element was prepared in the same manner as in Example 1 except that a copper thin film was formed by vacuum vapor deposition.

A resistance heating method was used as a vapor deposition source for vacuum-vapor depositing the copper thin film on the PET film, the base material temperature was set to 50°C, and the gas pressure was set to 5×10⁻³ Pa.

The capacitive reactance Xc and the equivalent series resistance ESR of the prepared piezoelectric element were measured by the method described above. Fig. 12 is a graph of the measured frequency and the measured resistance value. With reference to Fig. 12, the capacitive reactance Xc at 1 kHz was 151 Ω, and the equivalent series resistance ESR was 11.8 S2. Therefore, the ratio Xc/ESR of the capacitive reactance Xc to the equivalent series resistance ESR was 12.8. Further, the capacitive reactance Xc at 20 kHz was 8.33 Ω, and the equivalent series resistance ESR was 1.25 Ω. Therefore, the ratio Xc/ESR of the capacitive reactance Xc to the equivalent series resistance ESR was 6.7. The ratio Xc/ESR at 20 kHz in a case where the ratio Xc/ESR at 1 kHz was set to 1, that is, XE₂₀ was 0.52.

In addition, the capacitance of the prepared laminated piezoelectric element was 1.2 µF. C/(A × t) was 200.0 µF/mm³.

### [Comparative Example 2]

A bellows type piezoelectric element was prepared in the same manner as in Example 1 except that the gas pressure during the sputtering of the copper thin film on the PET film was set to 1.2 Pa, and the base material temperature (temperature of the PET film) was set to 60°C. In the columns of the method of forming the electrode layer in Table 1, a case where the sputtering was performed under the same conditions as in Comparative Example 2 is listed as "sputtering 2".

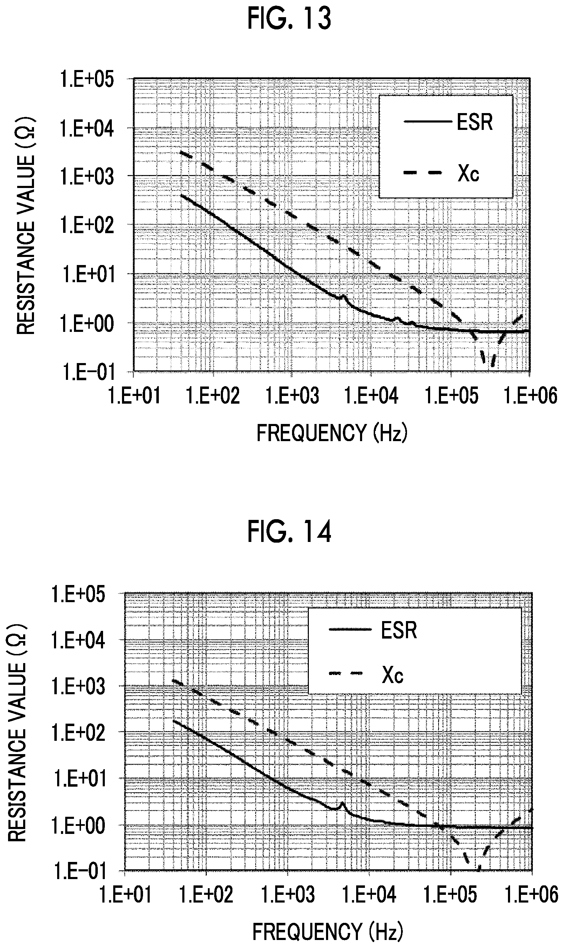

The capacitive reactance Xc and the equivalent series resistance ESR of the prepared piezoelectric element were measured by the method described above. Fig. 13 is a graph of the measured frequency and the measured resistance value. With reference to Fig. 13, the capacitive reactance Xc at 1 kHz was 152 Ω, and the equivalent series resistance ESR was 11.6 S2. Therefore, the ratio Xc/ESR of the capacitive reactance Xc to the equivalent series resistance ESR was 13.1. Further, the capacitive reactance Xc at 20 kHz was 8.34 Ω, and the equivalent series resistance ESR was 1.15 S2. Therefore, Therefore, the ratio Xc/ESR of the capacitive reactance Xc to the equivalent series resistance ESR was 7.25. The ratio Xc/ESR at 20 kHz in a case where the ratio Xc/ESR at 1 kHz was set to 1, that is, XE₂₀ was 0.55.

In addition, the capacitance of the prepared laminated piezoelectric element was 1.2 µF. C/(A × t) was 200.0 µF/mm³.

### [Comparative Example 3]

The piezoelectric film prepared in Example 1 was cut into a size of 200 mm × 380 mm in plan view and folded back nine times in the longitudinal direction to prepare a bellows type piezoelectric element 56. The surfaces in contact with each other by folding back the film were bonded to each other using a thermal adhesive sheet (FB-ML4, manufactured by Nitto Shinko Corporation).

In addition, the first electrode layer 24 and the wire were connected to each other on one end side of the long side of the folded-back piezoelectric film, and the second electrode layer 26 and the wire were connected to each other on the other end side thereof.

The capacitive reactance Xc and the equivalent series resistance ESR of the prepared piezoelectric element were measured by the method described above. Fig. 14 is a graph of the measured frequency and the measured resistance value. With reference to Fig. 14, the capacitive reactance Xc at 1 kHz was 64.1 Ω, and the equivalent series resistance ESR was 6.12 S2. Therefore, the ratio Xc/ESR of the capacitive reactance Xc to the equivalent series resistance ESR was 10.5. Further, the capacitive reactance Xc at 20 kHz was 3.66 Ω, and the equivalent series resistance ESR was 1.05 Ω. Therefore, the ratio Xc/ESR of the capacitive reactance Xc to the equivalent series resistance ESR was 3.49. The ratio Xc/ESR at 20 kHz in a case where the ratio Xc/ESR at 1 kHz was set to 1, that is, XE₂₀ was 0.33.

In addition, the capacitance of the prepared laminated piezoelectric element was 2.4 µF. C/(A × t) was 400.0 µF/mm³.

### [Comparative Example 4]

A bellows type piezoelectric element was prepared in the same manner as in Comparative Example 2 except that the opening area A of the hole portion was set to 20 mm².

The capacitive reactance Xc and the equivalent series resistance ESR of the prepared piezoelectric element were measured by the method described above. The capacitive reactance Xc at 1 kHz was 150 Ω, and the equivalent series resistance ESR was 13.5 S2. Therefore, the ratio Xc/ESR of the capacitive reactance Xc to the equivalent series resistance ESR was 11.1. Further, the capacitive reactance Xc at 20 kHz was 8.31 Ω, and the equivalent series resistance ESR was 1.41 S2. Therefore, the ratio Xc/ESR of the capacitive reactance Xc to the equivalent series resistance ESR was 5.9. The ratio Xc/ESR at 20 kHz in a case where the ratio Xc/ESR at 1 kHz was set to 1, that is, XE₂₀ was 0.53.

In addition, the capacitance of the prepared laminated piezoelectric element was 1.2 µF. C/(A × t) was 600.0 µF/mm³.

### [Comparative Example 5]

A bellows type piezoelectric element was prepared in the same manner as in Comparative Example 2 except that the thicknesses of the first electrode layer 24 and the second electrode layer 26 (copper thin film) were set to 300 nm and the opening area A of the hole portion was set to 8 mm².

The capacitive reactance Xc and the equivalent series resistance ESR of the prepared piezoelectric element were measured by the method described above. The capacitive reactance Xc at 1 kHz was 146 Ω, and the equivalent series resistance ESR was 12.2 S2. Therefore, the ratio Xc/ESR of the capacitive reactance Xc to the equivalent series resistance ESR was 12.0. Further, the capacitive reactance Xc at 20 kHz was 8.42 Ω, and the equivalent series resistance ESR was 1.22 Ω. Therefore, the ratio Xc/ESR of the capacitive reactance Xc to the equivalent series resistance ESR was 6.90. The ratio Xc/ESR at 20 kHz in a case where the ratio Xc/ESR at 1 kHz was set to 1, that is, XE₂₀ was 0.58.

In addition, the capacitance of the prepared laminated piezoelectric element was 1.2 µF. C/(A × t) was 500.0 µF/mm³.

### [Evaluation]

The prepared laminated piezoelectric element was connected to a continuous driving tester (40 Vrms), the laminated piezoelectric element was hung in the air and continuously driven for 1 hour, and the reaching temperature of the laminated piezoelectric element was measured. An SN2 signal was used as the input signal. The SN2 signal is a noise signal standard defined by JEITA, and is a noise signal obtained by cutting a high-frequency component and a low-frequency component of a white noise signal. The frequency of the applied voltage was set to be in a range of 20 Hz to 20 kHz. Further, the measurement site of the temperature of the laminated piezoelectric element was set to an optional position where the maximum reaching temperature was shown.

The results are listed in Table 1.

**[Table 1]**

| | Electrode layer | | | Opening area A of hole portion mm² | Capacitance C µF | C/(A·t) µF/mm³ | Lamination method | Number of laminated layers | XE₂₀ | Evaluation |
|---|---|---|---|---|---|---|---|---|---|---|
| | Material | Thickness t nm | Forming method | | | | | | | Reaching temperature °C |
| Example 1 | Copper | 100 | Sputtering 1 | 60 | 1.2 | 200.0 | Bellows type | 5 layers | 0.89 | 61 |
| Example 2 | Copper | 150 | Sputtering 1 | 60 | 1.2 | 133.3 | Bellows type | 5 layers | 1.18 | 55 |
| Example 3 | Copper | 100 | Sputtering 1 | 60 | 1.2 | 200.0 | Sheet type | 5 layers | 0.99 | 57 |
| Example 4 | Copper | 150 | Ion-assisted vapor deposition | 60 | 1.2 | 133.3 | Sheet type | 5 layers | 0.93 | 61 |
| Example 5 | Copper | 150 | Sputtering 1 | 40 | 1.2 | 200.0 | Bellows type | 5 layers | 1.08 | 57 |
| Example 6 | Copper | 300 | Sputtering 1 | 20 | 1.2 | 200.0 | Bellows type | 5 layers | 1.21 | 54 |
| Example 7 | Copper | 300 | Sputtering 1 | 30 | 1.2 | 133.3 | Bellows type | 5 layers | 1.33 | 51 |
| Example 8 | Copper | 300 | Sputtering 1 | 15 | 1.2 | 266.7 | Bellows type | 5 layers | 1.12 | 60 |
| Comparative Example 1 | Copper | 100 | Vacuum vapor deposition | 60 | 1.2 | 200.0 | Bellows type | 5 layers | 0.52 | 67 |
| Comparative Example 2 | Copper | 100 | Sputtering 2 | 60 | 1.2 | 200.0 | Bellows type | 5 layers | 0.55 | 65 |
| Comparative Example 3 | Copper | 100 | Sputtering 1 | 60 | 2.4 | 400.0 | Bellows type | 10 layers | 0.33 | 73 |
| Comparative Example 4 | Copper | 100 | Sputtering 2 | 20 | 1.2 | 600.0 | Bellows type | 5 layers | 0.53 | 82 |
| Comparative Example 5 | Copper | 300 | Sputtering 2 | 8 | 1.2 | 500.0 | Bellows type | 5 layers | 0.58 | 71 |

As shown in Table 1, it was found that the piezoelectric element of the present invention had a reaching temperature lower than those of the comparative examples and was capable of suppressing heat generation. Further, based on the comparison between Example 1 and Comparative Example 2, it was found that even in a case where the same film forming method was used, the film quality was changed depending on the film forming conditions and the heat generation was increased in a case where the film quality was poor. Further, based on the comparison between Example 1 and Comparative Example 3, it was found that the heat generation was increased in a case where the length of the path through which the current flowed was increased.

Further, based on the comparison between Examples 1 and 3, it was found that in a case where the piezoelectric element was obtained by laminating the piezoelectric films, it was preferable to connect the piezoelectric films in parallel.

In addition, based on the comparison between Examples 2 and 5 and the comparison between Examples 6 to 8, it was found that the reaching temperature was lower as C/(A × t) was smaller, and C/(A × t) was preferably 260.0 µF/mm³ or less.

### [Reference Example 1]

Sheet-like materials 10a and 10c formed by vacuum-vapor depositing a copper thin film having a thickness of 300 nm on a PET film having a thickness of 5 µm were prepared. The conditions for vacuum-vapor depositing the copper thin film were set to be the same as those in Comparative Example 1. That is, in the present example, the first electrode layer 24 and the second electrode layer 26 are copper thin films having a thickness of 300 nm, and the first protective layer 28 and the second protective layer 30 are PET films having a thickness of 5 µm.

A long piezoelectric film 10L was prepared by forming a piezoelectric layer 20 having a thickness of 50 µm using the sheet-like materials 10a and 10c in the same manner as in Example 1.

The prepared piezoelectric film was cut into a size of 150 mm × 200 mm in plan view and folded back four times in a direction of 150 mm to prepare a bellows type laminated piezoelectric element. That is, the short side of the laminated piezoelectric element was set to 30 mm, and the long side thereof was set to 200 mm. Further, the surfaces in contact with each other by folding back the film were bonded to each other using a butadiene-based pressure sensitive adhesive. The thickness of the adhesive layer was set to 30 µm.

In addition, the first electrode layer 24 and the wire were connected to each other on one end side of the long side of the laminated piezoelectric element after the folding back, and the second electrode layer 26 and the wire were connected to each other on the other end side thereof.

### [Reference Examples 2 and 3]

Laminated piezoelectric elements were prepared in the same manner as in Reference Example 1 except that the lengths of the long sides were set to 260 mm and 320 mm.

### [Evaluation]

The prepared laminated piezoelectric element was attached to a vibration plate as an exciter, and the sound pressure was measured.

A duralumin plate having a thickness of 0.8 mm, a length of 450 mm, and a width of 500 mm was used as the vibration plate. The laminated piezoelectric element was bonded to substantially the center of the vibration plate such that the lateral direction of the vibration plate and the longitudinal direction of the laminated piezoelectric element were made to match each other.

The laminated piezoelectric element was connected to a continuous driving tester and driven at an applied voltage of 40 Vrms, and the sound pressure was measured with a microphone placed at a distance of 1 m separated from the center of the vibration plate. The measurement results of the sound pressure at each frequency of 1 kHz to 20 kHz are listed in Table 2.

**[Table 2]**

| | Length of long side mm | Sound pressure (dB) | | | | | | | |
|---|---|---|---|---|---|---|---|---|---|
| | | 1 kHz | 1.3 kHz | 1.5 kHz | 2 kHz | 5 kHz | 10 kHz | 15 kHz | 20 kHz |
| Reference Example 1 | 200 | 70 | 90 | 92 | 95 | 74 | 76 | 91 | 85 |
| Reference Example 2 | 260 | 77 | 91 | 94 | 97 | 76 | 79 | 92 | 85 |
| Reference Example 3 | 320 | 80 | 93 | 96 | 98 | 96 | 81 | 92 | 85 |

As shown in Table 2, it was found that the sound pressure mainly at a frequency of 1 kHz to 15 kHz was uniformly improved by increasing the length of the long side.

Further, in a case where the applied voltage was set to 40 Vrms, the temperature of the laminated piezoelectric element having a long side length of 200 mm was approximately 40°C. The applied voltage to the laminated piezoelectric element having a long side length of 260 mm was adjusted to acquire the applied voltage at the same sound pressure as in a case of an applied voltage of 40 Vrms to the laminated piezoelectric element having a long side length of 200 mm, and the value was 32 Vrms. Here, the temperature of the laminated piezoelectric element was approximately 33°C. That is, in a case where the same sound pressure as that of the long side length of 200 mm and an applied voltage of 40 Vrms was realized in the laminated piezoelectric element having a long side length of 260 mm, the temperature of the laminated piezoelectric element was lowered by approximately 7°C.

As shown in the results described above, it was found that since the sound pressure can be further increased at the same applied voltage by increasing the length of the long side of the laminated piezoelectric element, the voltage for obtaining the same sound pressure can be further decreased, and thus the heat generation can be further reduced.

From the above results, the effect of the present invention is clearly exhibited.

### Explanation of References

10: piezoelectric film
10a, 10c: sheet-like material
10b: laminate
12: vibration plate
16, 19: adhesive layer
20: piezoelectric layer
24: first electrode layer
26: second electrode layer
28: first protective layer
30: second protective layer
34: viscoelastic matrix
36: piezoelectric particle
50, 56: piezoelectric element
58: core rod
60: projecting portion
62, 64: electrode lead-out portion
70: hole portion
72: conductive member
74a, 74b: conductive wire

## Claims

1. A laminated piezoelectric element comprising:
a piezoelectric film,
wherein the laminated piezoelectric element is obtained by laminating a plurality of layers of piezoelectric films each including a piezoelectric layer consisting of a polymer-based piezoelectric composite material that contains piezoelectric particles in a matrix containing a polymer material, and electrode layers formed on both surfaces of the piezoelectric layer, and
in a case where a value obtained by dividing a capacitive reactance Xc of the piezoelectric film at a frequency of 1 kHz by an equivalent series resistance ESR is set to 1, a value XE₂₀ obtained by dividing the capacitive reactance Xc at a frequency of 20 kHz by the equivalent series resistance ESR is in a range of 0.6 to 1.5.

2. The laminated piezoelectric element according to claim 1,
wherein the polymer material has viscoelasticity at room temperature.

3. The laminated piezoelectric element according to claim 1 or 2,
wherein the value XE₂₀ is in a range of 0.8 to 1.3.

4. The laminated piezoelectric element according to any one of claims 1 to 3,
wherein the electrode layers each have a thickness of 1 µm or less.

5. The laminated piezoelectric element according to any one of claims 1 to 4,
wherein the piezoelectric film laminated at least on an outermost layer of the laminated piezoelectric element includes a protective layer laminated on a surface of the electrode layer on the outermost layer sides opposite to the piezoelectric layer,
the protective layer has a hole portion penetrating from a surface to the electrode layer, and
the laminated piezoelectric element has a conductive member disposed in the hole portion, and
a conductive wire disposed on the surface of the hole portion of the protective layer and electrically connected to the electrode layer via the conductive member.

6. The laminated piezoelectric element according to claim 5,
wherein in a case where an opening area of the hole portion is defined as A, a thickness of the electrode layer is defined as t, and a capacitance of the laminated piezoelectric element is defined as C, C/(A × t) is 260 µF/mm³ or less.
